(19) Europäisches Patentamt
European Patent Office
Office européen des brevets

(11) **EP 2 382 656 B1**

(12) **EUROPÄISCHE PATENTSCHRIFT**

(45) Veröffentlichungstag und Bekanntmachung des Hinweises auf die Patenterteilung:
**03.10.2018 Patentblatt 2018/40**

(21) Anmeldenummer: **09795451.5**

(22) Anmeldetag: **23.12.2009**

(51) Int Cl.:
**H01L 21/68** *(2006.01)*

(86) Internationale Anmeldenummer:
**PCT/EP2009/067893**

(87) Internationale Veröffentlichungsnummer:
**WO 2010/072826 (01.07.2010 Gazette 2010/26)**

(54) **TRENNVERFAHREN FÜR EIN SCHICHTSYSTEM UMFASSEND EINEN WAFER**

METHOD FOR SEPARATING A LAYER SYSTEM COMPRISING A WAFER

PROCÉDÉ DE SÉPARATION POUR SYSTÈME STRATIFIÉ COMPRENANT UNE TRANCHE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **23.12.2008 DE 102008055155**
**29.01.2009 EP 09151661**

(43) Veröffentlichungstag der Anmeldung:
**02.11.2011 Patentblatt 2011/44**

(73) Patentinhaber: **Nissan Chemical Corporation Tokyo (JP)**

(72) Erfinder: **RICHTER, Franz**
**82223 Eichenau (DE)**

(74) Vertreter: **Eisenführ Speiser**
**Patentanwälte Rechtsanwälte PartGmbB**
**Postfach 10 60 78**
**28060 Bremen (DE)**

(56) Entgegenhaltungen:
WO-A1-2007/099146      JP-A- 2006 032 506
US-A1- 2003 000 635    US-A1- 2003 077 854
US-A1- 2004 168 764    US-A1- 2005 032 332
US-B1- 6 342 434

**Beschreibung**

Die Erfindung betrifft ein Verfahren zum mechanischen Trennen eines Schichtverbundes von einem ersten Trägerverbund, umfassend einen oder bestehend aus einem ersten Träger, wobei der Schichtverbund einen Wafer und gegebenenfalls einen zweiten, dehnbaren Träger umfasst. Sie betrifft ferner die Verwendung einer bestimmten Trennhilfe zum Trennen eines Schichtverbundes sowie eine Vorrichtung zur Durchführung des erfindungsgemäßen Verfahrens.

Stand der Technik

In der Halbleiterindustrie besteht ein stetiger Bedarf nach immer dünneren Bauteilen bzw. Wafern, aus denen diese Bauteile vereinzelt werden. Bei der Herstellung und insbesondere beim Dünnen von Wafern kommen Schichtverbundlösungen zum Einsatz, um den zu dünnenden Wafer während des Dünnprozesses zu schützen und mechanisch zu stabilisieren. Diese Schichtsysteme führen die genannten Funktionen auch bei weiteren Verarbeitungsschritten aus. Insbesondere aber dienen sie dazu, gedünnte Wafer, die aufgrund ihrer geringen Dicke mechanisch besonders empfindlich sind, zu stabilisieren. Zum Einsatz kommen dabei Schichtsysteme aus für den jeweiligen Zweck möglichst geeigneten Materialien wie z.B. Folien, weitere Wafer oder Glasplatten. Diese Teile der Schichtsysteme können wiederum kombiniert werden mit Wachs, Elastomeren oder anderen Kunststoffen.

Wenn in solchen Schichtsystemen eine Glasplatte oder eine Scheibe mit den dem zu dünnenden Wafer vergleichbaren mechanischen Eigenschaften - wie sie natürlich insbesondere ein weiterer Wafer besitzt - als Träger eingesetzt wird, der insbesondere dazu dienen soll, das gesamte Schichtsystem zu stabilisieren, ist es vorteilhaft und unter Umständen sogar notwendig, dass zwischen der zu schützenden Oberfläche und diesem Träger eine Schicht vorhanden ist, die den zu bearbeitenden Wafer und den Träger miteinander verbindet. Diese Schicht muss einerseits eine ausreichende Haftung zwischen dem Träger und dem zu bearbeitenden Wafer gewährleisten, andererseits muss sie in der Lage sein, die regelmäßig auf der Oberfläche des zu bearbeitenden Wafers vorhandenen topografischen Unebenheiten auszugleichen. Diese topografischen Unebenheiten sind beispielsweise durch elektronische Bauelemente auf der aktiven und beim Dünnen selbstverständlich zu schützenden Seite des Wafers bedingt wie auch z.B. durch Kontakte wie Bumps. Die verbindende Schicht kann selbstverständlich auch ein Schichtsystem sein, das mehrere verschiedene Schichten umfasst, die sich hinsichtlich ihrer Eigenschaften, wie z.B. Haftvermittlung, Elastizität, Härte, Wärmeleitfähigkeit, chemische Beständigkeit usw. im Sinne des Anwendungszweckes vorteilhaft ergänzen.

Bei der Herstellung von sehr dünnen Wafern wird durch das Dünnen eine hohe mechanische Belastung auf den zu dünnenden Wafer ausgeübt. Da der zu dünnende Wafer oft schon eine Vielzahl von Fertigungsschritten durchlaufen hat und insbesondere schon häufig die elektronischen Bauelemente auf seiner aktiven Seite (Vorderseite) umfasst, ist es auch aus wirtschaftlicher Sicht von hoher Bedeutung, dass während des Dünnens ein Bruch des Wafers und somit Ausschuss so weit wie möglich vermieden wird. Dazu wird der Wafer vor Auftreten hoher mechanischer Belastung noch im ungedünnten Zustand mit dem Träger verbunden. Dabei muss selbstverständlich die zu dünnende Rückseite (also die Seite, die die elektronischen Bauelemente nicht umfasst) frei bleiben. Das Verbinden des Wafers mit seinem Träger wird auch als Bonden bezeichnet.

Nach dem Bonden wird der Wafer von seiner Rückseite her gedünnt, wodurch er - wie oben bereits angedeutet - an mechanischer Stabilität verliert. Dieses wird während des Dünnens und nachfolgend durch den Träger ausgeglichen. Dementsprechend muss der Träger desto mehr stabilisierend wirken, je dünner der Wafer am Ende des Dünnprozesses vorliegt. Dementsprechend können bei verhältnismäßig dicken Wafern als Endprodukt auch Folien als Träger dienen. Grundsätzlich ist es möglich, dass der Wafer beim Dünnen bereits in seine einzelnen Bauelemente vereinzelt wird. Dies ist in vielen Fällen erwünscht, da so ein nachfolgender Vereinzelungsschritt erspart bleibt. Das Vereinzeln kann z.B. dadurch erfolgen, dass auf der aktiven Seite des Wafers zwischen den einzelnen Bauelementen (Dices) Vertiefungen vorgesehen werden, die tief genug sind, dass während des Abdünnens der Rückseiten diese Vertiefungen bereits berührt werden und somit durchgehend sind.

Das Unternehmen DISCO HI-TEC bietet ein Verfahren an, das "Dicing by Grinding" genannt wird und bei dem der Wafer mittels Abdünnens auch vereinzelt werden kann. Hierbei werden vor dem Aufbringen des Trägers auf der Wafer-Vorderseite Strukturen eingeschliffen, geritzt oder geätzt. Diese Strukturen haben dabei eine Tiefe, die größer ist als die Enddicke des Wafers, auf die abgedünnt wird. Durch das Abdünnen werden dementsprechend, wie oben beschrieben, die Strukturen geöffnet und der Wafer somit vereinzelt.

Das Vereinzeln führt dazu, dass sich zwar insgesamt die Bruchgefahr verringert, aber die vereinzelten Bauelemente ihrerseits wiederum vor mechanischen Belastungen geschützt werden müssen.

Problematisch beim Dünnen ist stets, dass nach dem Dünnen der Träger von dem Wafer getrennt werden muss. Insbesondere muss der Träger deshalb getrennt werden, weil er den Zugang zu den elektronischen Bauelementen auf der aktiven Seite des Wafers blockiert. Das Entfernen des Trägers ist bei verhältnismäßig dicken Wafern aus zwei Gründen im Regelfall unproblematisch:

- Der verhältnismäßig dicke (nur wenig gedünnte) Wafer ist noch zu einem gewissen Maß mechanisch belastbar und

- je mechanisch belastbarer der Wafer in seiner Enddicke ist, desto flexiblere Träger können eingesetzt werden. Dementsprechend können flexible Träger z.B. in Folienform einfach mechanisch abgezogen werden.

Bei wenig flexiblen Trägern, wie z.B. Glasplatten oder weiteren Wafern, ist ein derartiges Abziehen natürlich nicht möglich. Hier ist das Trennen besonders schwierig, da harte Träger insbesondere bei stark gedünnten Wafern eingesetzt werden, so dass hohe mechanische Belastungen unbedingt vermieden werden müssen.

Hierzu werden oft Schichten zwischen dem Wafer und dem Träger eingesetzt, die durch chemische oder physikalische Veränderung die Haftkraft zwischen dem Wafer und dem Träger verringern bzw. verlieren. Ein Beispiel für eine solche Schicht ist Wachs, welches durch Hitzeeinfluss weich wird und damit die Trennung erleichtert. Hierzu wird das Wachs erwärmt, bis es ausreichend flüssig ist, dass der Träger gegenüber dem Wafer verschoben werden kann. Nachteilig an diesem Verfahren ist, dass insbesondere die empfindliche Waferoberfläche, die die elektronischen Bauteile umfasst bzw. die Kontakte zu diesen, nachfolgend gereinigt werden muss.

Grundsätzlich ist auch der Einsatz von speziellen Adhäsiven möglich, die wiederum durch thermische oder Strahleneinwirkung ihre Haftvermittlung verringern. Ein solches Verfahren bietet z.B. der Hersteller 3M an, bei dem das Ablösen einer Haftvermittlungsschicht unter dem Einsatz von Laserenergie bewirkt wird.

Auch hier ist wiederum problematisch, dass Teile der haftvermittelnden Schicht auf der Waferoberfläche verbleiben, die aufwändig gereinigt werden muss.

Da das Reinigen zusätzlichen Aufwand bedeutet, den gedünnten Wafer mechanisch und oft auch chemisch zusätzlich belastet und/oder es nur sehr schwer gewährleistet werden kann, dass alle Adhäsivreste ausreichend beseitigt werden, sind für viele Anwendungen rein mechanische Lösungen bevorzugt, bei denen eine Trennschicht mechanisch von der aktiven Seite des Wafers abgezogen wird, so dass keine Rückstände verbleiben.

Eine solche Trennschicht ist in der WO 2004/051708 offenbart. Diese Trennschicht wird ihrerseits in dem in der WO 2007/099146 offenbarten, weiterentwickelten Abdünnverfahren eingesetzt. In der letztgenannten Patentanmeldung wird nach dem Abdünnen des Wafers auf der (abgedünnten) Rückseite ein zweiter Träger vorgesehen, der den Trennprozess vom ersten Träger unterstützen soll. Die Trennung erfolgt zwischen der Trennschicht und der aktiven Seite des Wafers. In der WO 2007/099146 ist dabei ein mechanisches Trennverfahren offenbart, bei dem der Verbund aus Wafer und zweitem Träger über eine Walze geführt wird, so dass der Trennvorgang mechanisch bewirkt wird. Dieser zweite Träger ist dabei häufig eine Sägefolie. Bei diesem Verfahren muss der zweite Träger flexibel sein, da er einer Krümmung folgen können muss.

Problematisch bei diesem Verfahren ist, dass der dehnbare Träger beim Trennen seinerseits eine Verformung zusätzlich zu der durch die Walze verursachten Krümmung durchlaufen kann, so dass der Trennvorgang nicht ausreichend kontrolliert abläuft. Insbesondere bei sehr dünnen Wafern, die ja mechanisch besonders empfindlich sind, führt das in der WO 2007/099146 offenbarte Verfahren beim Einsatz der Umlenkrolle zu häufig zu starken Kräften senkrecht zur Waferebene, so dass es zum Bruch des Wafers kommen kann, weil der dehnbare Träger die Krümmung der Walzenoberfläche nicht vollständig nachvollzieht. Dies hat zur Folge, dass die Trennfront nicht direkt unter der Auflage der Walze liegt, sondern leicht lateral verschoben ist. Dadurch erhöht sich der senkrechte Anteil der auf den Wafer ausgeübten Kraft.

Aufgabe der vorliegenden Erfindung war es daher, ein Verfahren anzugeben, mittels dessen eine möglichst sichere und sanfte Trennung des Wafers von dem während des Abdünnens stabilisierenden Träger ermöglicht wird.

Diese Aufgabe wird gelöst durch ein Verfahren zum mechanischen Trennen eines Schichtverbundes von einem Trägerverbund umfassend einen oder bestehend aus einem ersten Träger, wobei der Schichtverbund einen Wafer und gegebenenfalls einen zweiten, dehnbaren Träger umfasst (oder aus dem Wafer besteht), umfassend folgende Schritte:

a) Bereitstellen eines Schichtsystems umfassend den Trägerverbund und den Schichtverbund
b) Erzeugen einer mechanischen Spannung im Bereich der Grenzfläche zwischen Trägerverbund und dem Schichtverbund, so dass der Schichtverbund vom Trägerverbund getrennt wird, durch ein Verfahren umfassend

i) die Schritte:

i a) Bereitstellen einer Trennhilfe,
i b) Fixieren der Trennhilfe an dem zweiten Träger so, dass während des Trennvorganges der zweite Träger unmittelbar hinter einer beim Trennen entstehenden Trennfront an der Trennhilfe fixiert bleibt, und
i c) mechanisches Trennen des Schichtverbundes von dem Trägerverbund (1a) unter Ausnutzen nur genau einer Trennfront,
wobei die weiteren Merkmale des Anspruches 1 ebenfalls verwirklicht sind.
Möglich ist zusätzlich folgender Schritt:

ii) Erzeugen einer Vibration im Schichtsystem,
und/oder iii) folgender Schritt:
iii) Veränderung der Temperatur des Schichtsystems oder von Teilen des Schichtsystems

Bei dem Wafer kann es sich bevorzugt um Siliciumwafer handeln, die gegebenenfalls dotiert sind. Auch Wafer aus AlSb, AlAs, AlN, AlP, BN, BP, BAs, GaSb, GaAs, GaN, GaP, InSb, InAs, InN oder InP können für viele Anwendungen bevorzugt sein.

Sofern im Rahmen des nachfolgenden Textes nicht gesondert darauf hingewiesen wird, können regelmäßig anstelle des Wafers, der abgetrennt werden soll, auch die aus einem Wafer bereits vereinzelten Bauelemente verstanden werden.

Ein dehnbarer Träger ist in diesem Zusammenhang ein Träger, der unter den mechanischen Trennbedingungen des durchgeführten Trennverfahrens verformt und insbesondere gedehnt werden kann. Dieses Dehnen ist insbesondere deshalb problematisch, da dadurch das Kontrollieren einer Trennfront (siehe unten) nicht ausreichend möglich ist, wenn die Dehnbewegung nicht als solche kontrolliert wird. Bevorzugte dehnbare Träger sind die in der Industrie üblicherweise verwendeten Sägefolien aber auch andere, einseitig klebende oder sonstwie haftende Folien.

"Fixieren" bedeutet im Zusammenhang mit dieser Anmeldung, dass ein Verbund durch eine Kraft hergestellt wird, die senkrecht zwischen den zwei zu fixierenden Bereichen wirkt. Bevorzugte Methoden des Fixierens sind Kleben, Ansaugen durch Unterdruck, elektrostatisches Haltern. Nicht zum Fixieren im Sinne dieser Anmeldung gehört ausdrücklich das in der WO 2007/099146 gezeigte Führen über eine Walze aufgrund von Zugkraft.

Die Trennfront ist im Zusammenhang mit dem erfindungsgemäßen Verfahren im Rahmen dieses Textes der Bereich, in dem die Trennung stattfindet. Dies bedeutet, es handelt sich im idealen Fall um eine Linie, in der die Haftkraft zwischen den zu trennenden Bereichen sprungartig von 100% auf 0% fällt. Praktisch wird die Trennfront stets eine Fläche sein, wobei im Rahmen dieser Fläche die Haftkraft von < 100% bis > 0 reicht. Das Ende der Trennfront ist dabei selbstverständlich der Bereich, wo die Haftkraft 0 erreicht hat, der Anfang, wo sie gerade < 100% ist. Die Trennfront verschiebt sich bei einem üblichen Trennvorgang über die Trennebene, bis die voneinander zu trennenden Flächen getrennt sind, mithin keine Haftkraft mehr gegeneinander ausüben.

Die Haftkraft (Haftfestigkeit) zwischen den Bereichen kann der Fachmann nach der DIN 971/1:1996/09 bestimmen und sie wird definiert als die "Gesamtheit der Bindekräfte zwischen einer Beschichtung und ihrem Untergrund".

Der Schritt i b) des erfindungsgemäßen Verfahrens erfolgt dabei so, dass der zweite Träger gezwungen ist, in dem Bereich, der unmittelbar hinter der Trennfront liegt, also an diese angrenzt, in dem aber bereits die Trennung zwischen Schichtverbund und dem Trägerverbund erfolgt ist, den Bewegungen der Trennhilfe exakt zu folgen. Anders ausgedrückt führt die (flächige) Fixierung dazu, dass sich die Dehnbarkeit des zweiten Trägers nicht auf die Lage der Trennfront auswirkt. In dem in der WO 2007/099146 offenbarten Verfahren würde sich entgegen dem erfindungsgemäßen Verfahren ein dehnbarer zweiter Träger sich (wenn auch nur leicht) von der Umlenkrolle ablösen können, da die Haftkraft zwischen Wafer und erstem Träger einem idealen Folgen der Umlenkrollenbewegung (bzw. entlang des Umfanges der Umlenkrolle) entgegenwirkt.

Eine Aufgabe der vorliegenden Erfindung ist diesen negativen Effekt aufzuheben. Dabei muss dafür Sorge getragen werden, dass der zweite, dehnbare Träger so an der Trennhilfe fixiert ist, dass die Lage der Trennfront von der Dehnbarkeit des Trägers nicht verändert wird. Wie bereits angedeutet ist dafür entscheidend, dass der Träger unmittelbar hinter der Trennfront so fixiert ist, dass er den Bewegungen der Trennhilfe folgen muss. Dabei kann diese Fixierung temporär während des Trennvorganges erfolgen, wie z.B. durch eine Walze, die unmittelbar hinter ihrer Auflagefläche durch elektrostatische Kraft den zweiten Träger flächig fixiert. Alternativ und bevorzugt wird der zweite Träger allerdings schon vor Beginn des Trennvorganges flächig an der Trennhilfe fixiert, wobei diese Fixierung während des Trennvorganges nicht aufgehoben wird. Für das Umsetzen der Erfindung ist dies aber nicht unbedingt notwendig, es hat nur Vorteile hinsichtlich der Praktikabilität.

Für den Fachmann unmittelbar nachvollziehbar im Sinne der vorliegenden Erfindung ist auch die Konstellation, dass unter dem Begriff, dass "der Träger unmittelbar hinter der Trennfront so fixiert ist, dass er den Bewegungen der Trennhilfe folgen muss" auch der Fall fällt, dass sich die Trennhilfe nicht bewegt, während das Schichtsystem zwischen erstem Träger und Wafer mechanisch so beeinflusst wird, dass eine Trennfront entsteht. Dies erfolgt zum Beispiel und bevorzugt dadurch, dass der erste Träger eine Glasplatte oder ein Wafer ist, und eine Kraft angelegt wird, die eine Seite der Glasplatte oder des Wafers von der Trennhilfe wegdrückt. Bei einer Auswahl einer entsprechenden Glassorte oder eines entsprechenden Wafermaterials sowie beim Einstellen der zum Wegdrücken angewandten Kraft führt dies zu einer (leichten) Krümmung der Glasplatte / des Wafers. Diese Krümmung führt zu einer Scherkraft im gesamten System, so dass eine Trennfront dort entsteht, wo die Schichten mit der geringsten Haftkraft zueinander aneinander stoßen. Bei der entsprechenden Einstellung des Schichtsystems ist diese Grenzfläche im Sinne der Erfindung die Oberfläche der aktiven Seite des Wafers.

Bei der Variante, dass der erste Träger gebogen wird, um die Trennung zu bewirken, ist es bevorzugt, dass als Trennhilfe eine Vorrichtung eingesetzt wird, die gegenüber dem ersten Träger, bevorzugt einer Glasplatte oder einem Wafer, eine höhere Biegesteifigkeit besitzt. Dadurch wird gewährleistet, dass die Trennhilfe nicht der Biegung der Glasplatte folgt und somit der Trennvorgang gut kontrollierbar ist. Für den Fachmann unmittelbar nachvollziehbar ist, dass auch bei der Trennvariante bei der der erste Träger gebogen wird, ein entscheidender Faktor die Kontrolle der Trennfront ist. Auch bei dieser Variante würde, wenn der zweite, dehnbare Träger der Biegebewegung des ersten Trägers (ggf. teilweise) folgen würde, es dazu führen, dass die Lage der Trennfront und damit die die Trennung bewirkenden Kräfte in ihrem Einfluss auf den gedünnten Wafer nicht optimal kontrolliert werden könnten. Auch bei der letztbeschriebenen Trennvariante kann die Fixierung des zweiten, dehnbaren Trägers an der Trennhilfe selbstverständlich temporär erfolgen, wobei natürlich darauf zu achten ist, dass die Fixierung stets vollständig im Bereich senkrecht zu der (sich fortbewegenden) Trennfront gewährleistet ist.

Generell ist im erfindungsgemäßen Verfahren bevorzugt, dass das Trennen nur durch das Ausnutzen genau einer Trennfront erfolgt. Denkbar sind zwar Trennvorgänge mit mehreren Trennfronten, zum Beispiel indem die Trennhilfe oder der erste Träger an den jeweils gegenüberliegenden Seiten einer Biegekraft ausgesetzt werden, es ist aber deutlich schwerer mehr als eine Trennfront zu kontrollieren und insbesondere im Bereich, wo die Trennfronten aufeinander stoßen treten schwer kontrollierbare Kraftverhältnisse auf.

Als Trennhilfe bieten sich einerseits dabei alle Gegenstände an, die eine (teilweise) konvexe Oberfläche besitzen, oder zu solch einer konvexen Oberfläche verformt werden können. Gleichzeitig muss die Trennhilfe so ausgestaltet sein, dass die Fixierung des zweiten Trägers wenigstens unmittelbar hinter der Trennfront gewährleistet ist. Geeignete Trennhilfen können z.B. Walzen, insbesondere solche mit einem großen Umfang sein oder aber auch flexible, biegbare Platten, wie z.B. Plexiglasscheiben, sonstige Kunststoffplatten oder dünne Metallplatten.

Andererseits können geeignete Trennhilfen auch starre Vorrichtungen sein (siehe oben), insbesondere wenn die die Trennung bewirkende Verformung nicht auf die Trennhilfe sondern zum Beispiel auf den ersten Träger ausgeübt wird.

Selbstverständlich ist es möglich, dass bei dem erfindungsgemäßen Verfahren zwischen dem ersten Träger und dem Wafer eine oder mehrere weitere Schichten vorhanden sind. Diese weiteren Schichten sind jeweils Bestandteil des Trägerverbundes oder des Schichtverbundes. Welchem dieser beiden Verbunde die jeweilige weitere Schicht zuzuordnen ist, ist im Sinne dieser Anmeldung davon abhängig, wo die zwei Schichten im Schichtsystem liegen, die zueinander die geringste Haftkraft besitzen. Die Grenzfläche zwischen diesen Schichten definiert die "Sollbruchlinie" für die Trennung, also die Grenzfläche zwischen dem Schichtverbund und dem Trägerverbund. Somit sind alle Schichten, die waferseitig dieser Grenzfläche sind, Teil des Schichtverbundes, während die Schichten auf Seiten des ersten Trägers von der genannten Grenzfläche aus gesehen, Bestandteil des Trägerverbundes sind. Dabei ist selbstverständlich nicht ausgeschlossen (sogar oft bevorzugt), dass die Grenzfläche mit der niedrigsten Haftkraft direkt an dem Wafer oder auch an den ersten Träger anliegt, die somit im Sinne der Zuordnung der einzelnen Schichten zu dem jeweiligen Verbund auch als Schicht aufzufassen sind.

Entsprechend kann der abzutrennende Schichtverbund weitere Schichten neben dem Wafer und dem zweiten (dehnbaren) Träger umfassen. Entscheidend für die Durchführung der vorliegenden Erfindung ist jedoch, dass die evtl. vorhandenen weiteren Schichten im abzutrennenden Schichtverbund vom Material her so ausgestattet sind, dass sie

a) einer für das Entstehen der Trennfront entscheidenden Krümmung der Trennhilfe (die gegebenenfalls erst während des Trennvorganges erzeugt werden kann) folgen bzw. falls der Trennvorgang nicht durch eine Krümmung der Trennhilfe bewirkt wird (sondern zum Beispiel durch Krümmung des ersten Trägers) gegenüber der Trennhilfe ungekrümmt verbleiben und

b) dass sie die Lage der Trennfront nicht dadurch beeinflussen, dass sie sich verformen.

Es muss noch angemerkt werden, dass das Fixieren des zweiten Trägers an die Trennhilfe "unmittelbar hinter der beim Trennen entstehenden Trennfront" sich von der Lage her auf die Ebene senkrecht zur Trennfront bezieht: Die Haftung zwischen Trennhilfe und zweitem Träger findet ja selbstverständlich nicht in der Trennebene statt.

Wie bereits oben angedeutet ist für das erfindungsgemäße Verfahren entscheidend, dass das Fixieren des zweiten Trägers an der Trennhilfe so erfolgt, dass die Trennfront nicht von den Materialeigenschaften des zweiten Trägers in ihrer Lage beeinflusst wird. Die Fixierung kann dauerhaft oder temporär sein und sie muss nicht den gesamten bereits abgetrennten Teil des zweiten Trägers umfassen. Entscheidend ist lediglich der Bereich hinter der Trennfront. Dabei bedeutet flächig im Sinne der Fixierung, dass senkrecht zur Trennrichtung in der Trennebene (bzw. in der aus der Trennebene herausragenden Krümmung der Trennhilfe) die Fixierungsfläche eine Tiefe größer als 0 umfasst, wobei die Breite der flächigen Fixierung bevorzugt durch die Trennfront vorgegeben ist.

Das mechanische Trennen im Schritt i c) des erfindungsgemäßen Verfahrens erfolgt bevorzugt durch Ausnutzen einer Krümmung, die entweder in der Trennhilfe bereits vorhanden ist oder in ihr erzeugt werden kann. Als ebenfalls bevorzugte Alternative erfolgt das mechanische Trennen im Schritt i c) gerade dadurch, dass die Trennhilfe einer Krümmung die anderweitig in das Gesamtschichtsystem gebracht wird (zum Beispiel durch Biegung des ersten Trägers) nicht folgt. Sofern die Trennhilfe z.B. eine Rolle ist, erfolgt das mechanische Trennen durch Abrollen der Rolle über die vom Wafer weg gerichtete Oberfläche des zweiten Trägers. Dabei muss der zweite Träger zunächst an der Rolle fixiert werden. Bevorzugt erfolgt die Fixierung in diesem Fall in einem Bereich, in dem der zweite Träger gegenüber dem Wafer übersteht (loses Ende). Nach der Fixierung wird die Rolle in einer rollenden Bewegung über die Oberfläche des Schichtsystems geführt, so dass auf das Schichtsystem eine Scherkraft wirkt (auch aufgrund der Fixierung des zweiten Trägers an der Rolle) und so - bei entsprechender Ausgestaltung des Schichtsystems - der Schichtverbund aus Wafer und zweiten, dehnbaren Träger von dem Rest des Schichtsystems, hier insbesondere dem ersten Träger (gemeinsam mit eventuell weiteren vorhandenen Schichten des Trägerverbundes, wie stets, wenn von der (Ab-)Trennung des ersten Trägers die Rede ist) getrennt wird. Wie bereits mehrfach beschrieben ist in diesem Zusammenhang entscheidend, dass die Fixierung des zweiten Trägers an der Trennhilfe (Rolle) stets unmittelbar hinter der Trennfront vorhanden ist. Diese Fixierung muss also im Falle einer Rolle während des Trennvorganges unmittelbar nach Abtrennen jedes Teilabschnittes des zweiten Trägers (und damit des abzutrennenden Schichtverbundes) erfolgen. Dabei werden selbstverständlich der zweite Träger und auch der mit ihm verbundene Wafer der Krümmung der Trennhilfe unterworfen.

In einem alternativen und bevorzugten Trennverfahren ist die Trennhilfe eben. Hier kann vor dem Trennen im Schritt i c) eine großflächige Fixierung von großen Teilen oder der gesamten Oberfläche des zweiten Trägers an der Trennhilfe erfolgen. Das Trennen erfolgt durch Biegen der Trennhilfe, so dass diese im Bereich der Trennfront (oder zunächst dort, wo die Trennfront entsteht) gegenüber dem Schichtsystem eine konvexe Krümmung (analog zu einer Walzenoberfläche mit großem Umfang) annimmt. Auch hier wird der zweite Träger aufgrund seiner Fixierung dazu gezwungen, der konvexen Krümmung der Trennhilfe zu folgen und mit ihm - wiederum bei entsprechender Ausgestaltung des Schichtsystems - der Wafer. Selbstverständlich muss für alle Trennvorgänge dafür Sorge getragen werden, dass der erste Träger nicht der erzwungenen konvexen Verformung des Schichtverbundes folgt, so dass eine Scherkraft zwischen Schichtverbund und erstem Träger entsteht.

Es sei noch einmal darauf hingewiesen, dass durch das erfindungsgemäße Verfahren eine besonders gute Kontrolle der Trennfront möglich ist. Faktisch wird - insbesondere bei einem hohen Radius der konvexen Krümmung im Bereich der Trennfront - die Trennfront in Trennrichtung verbreitert, das bedeutet, dass die Fläche, in der die Haftkraft gerade kleiner als 100% (also gerade kleiner als die Haftkraft ohne Einwirkung der Trennhilfe) ist, bis zur vollständigen Trennung (Haftkraft = 0) vergrößert wird. Dies führt dazu, dass der Kraftvektor, der auf das Schichtsystem einwirkt, einen verhältnismäßig geringen Teil senkrecht zur Trennebene besitzt. Dies bewirkt insbesondere, dass das unerwünschte Abknicken, wie es z.B. beim Abrollen von Tesafilm bekannt ist, vermieden wird. Mit anderen Worten, es ist aufgrund des erfindungsgemäßen Verfahrens gemäß Variante i) möglich, den besonders kritischen mechanischen Stress, also die Kraftwirkung, die senkrecht zur Trennebene erfolgt, zu begrenzen und zu kontrollieren. Dies kann z.B. durch den Einsatz geeigneter Materialien für die (gegebenenfalls biegbare) Trennhilfe, durch entsprechende Oberflächengeometrien (wie z.B. Walzendurchmesser) und natürlich durch geeignete Materialauswahl für den Träger (wie auch natürlich für das gesamte Schichtsystem) bewirkt werden.

Es entspricht dem erfindungsgemäßen Verfahren, dass das Fixieren der Trennhilfe an dem zweiten Träger mittels Unterdruck oder mittels elektrostatischer Aufladung erfolgt. Diese Formen der Fixierung haben den Vorteil, dass sie (wenn gewünscht) lokal, also nur auf einem Teil der Trennhilfe genau steuerbar eingesetzt werden können, insbesondere haben sie aber den Vorteil, dass die Fixierung durch Abschalten des Unterdrucks bzw. durch Aufheben der elektrostatischen Ladung leicht wieder rückgängig gemacht werden kann.

Wie bereits angedeutet, ist es mit dem erfindungsgemäßen Verfahren möglich, sehr dünne Wafer bzw. Schichtverbunde, die einen sehr dünnen Wafer umfassen, von einem ersten Träger zu trennen. Dementsprechend ist ein bevorzugtes erfindungsgemäßes Verfahren ein solches, wobei der Wafer eine Dicke von $\leq 400$ $\mu$m, bevorzugt $\leq 150$ $\mu$m, weiter bevorzugt $\leq 80$ $\mu$m, besonders bevorzugt von $\leq 20$ $\mu$m und ganz besonders bevorzugt $\leq 10$ $\mu$m besitzt.

Bevorzugt ist ein erfindungsgemäßes Verfahren, wobei das im Schritt a) bereitgestellte Schichtsystem zwischen dem Wafer und dem ersten Träger ein, zwei, drei, vier oder mehr Schichten aufweist und dass das Trennen, zwischen zwei angrenzenden Oberflächen dieser Schichten oder zwischen der Oberfläche des Wafers und der daran angrenzenden Schicht oder zwischen der Oberfläche des ersten Trägers und der daran angrenzenden Schicht erfolgt.

Bevorzugt ist in diesem Zusammenhang selbstverständlich, dass die Trennung zwischen der Oberfläche des Wafers (aktive Seite des Wafers) und der daran angrenzenden Schicht erfolgt. So ist es möglich, die aktive Seite zugänglich zu machen ohne dass noch zu reinigende Rückstände auf dem Wafer verbleiben.

Wie bereits oben angedeutet ist es insbesondere beim Erzeugen sehr dünner Wafer vorteilhaft, dass der erste Träger über eine hohe mechanische Festigkeit verfügt. Dementsprechend ist es für das erfindungsgemäße Verfahren bevorzugt, dass der erste Träger eine Glasplatte oder ein Siliciumwafer (mit einer größeren Dicke als der gedünnte Wafer) ist. Als Glasplatte bevorzugtes Material ist Borosilicatglas oder Quarzglas. Sofern der erste Träger aus unflexiblen Materialien ausgestaltet ist, ist eine Fixierung des ersten Trägers während des Trennvorganges nicht unbedingt erforderlich, da er nicht der konvexen Krümmung des Schichtverbundes (bestehend zumindest aus dem (gedünnten) Wafer und zweitem Träger) während des Trennens folgen kann. Dennoch ist es aus Gründen der Verfahrenssicherheit bevorzugt, auch einen unflexiblen ersten Träger während des Trennens zu fixieren.

Es kann sich beim ersten Träger aber auch um Material handeln, das auf die Waferoberfläche (unmittelbar oder mittelbar) durch Aufschleudern (Spin Coating), Aufsprühen (Spray Coating), Laminieren und/oder Verpressen aufgetragen wird. Dabei kann dieses Material vernetzt oder anderweitig in seiner Konsistenz modifiziert werden, um die gewünschten mechanischen Eigenschaften zu beeinflussen.

Bevorzugt ist ein erfindungsgemäßes Verfahren, wobei sich zwischen dem ersten Träger und dem Wafer mindestens eine plasmapolymere Trennschicht befindet. Eine Trennschicht hat die Aufgabe, gezielt eine Sollbruchlinie für die Trennung, also eine Ebene, in der die Trennfront verläuft während der Trennung zu ermöglichen und/oder zu gewährleisten. Zusätzlich oder alternativ soll die Trennschicht es ermöglichen oder erleichtern, den Wafer von dem nach dem Trennen eventuell verbleibenden (Rest-) Schichtsystem des Trägerverbundes einschließlich der Trennschicht selbst zu befreien, so dass der Wafer leicht gereinigt werden kann.

Beim Vorsehen einer Trennschicht im Sinne der Erfindung kann es bevorzugt sein, dass die Trennschicht so vorgesehen ist, dass die durch sie eingeführte Trennebene direkt an den Wafer angrenzt. In einigen Fällen kann es aber bevorzugt sein, dass die Trennschicht eine Trennebene definiert, durch die der erste Träger von in diesem Fall vorhandenen weiteren Schichten zwischen dem ersten Träger und dem Wafer getrennt wird. In diesem Fall würden eine oder mehrere Schichten auf dem Wafer verbleiben, die z.B. durch ein Peelingverfahren entfernt werden könnten. Letzteres kann durch das Vorsehen einer weiteren Trennschicht, die direkt an den Wafer grenzt und die die für das Peelingverfahren entscheidende Trennebene zwischen der weiteren Trennschicht und dem Wafer festlegt, unterstützt werden. Die Variante, dass noch weitere Schichten auf dem Wafer verbleiben (und damit Bestandteil des Schichtverbundes im Sinne der obigen Definition sind) kann dabei so ausgestaltet werden, dass die (eigentliche) Trennschicht ebenfalls Bestandteil des Schichtverbundes ist (und mithin nach der Trennung, ggf. mittelbar mit dem Wafer verbunden bleibt) oder dass die Trennschicht Bestandteil des Trägerverbundes ist (und nach dem Trennen ggf. mittelbar mit dem ersten Träger verbunden bleibt). Die hierfür jeweils notwendigen Ausgestaltungen dieser Trennschicht kann der Fachmann mit seinem Fachwissen und mit den Hinweisen aus dieser Anmeldung leicht vornehmen.

Angemerkt sei noch, dass die Trennebene abhängig von den Oberflächen, die voneinander getrennt werden, natürlich nicht durchgehend eben sein muss. Dies trifft insbesondere dann, wenn die Trennung zwischen einem strukturierten Bereich der Vorderseite (aktive Seite) des Wafers und einer darüber liegenden Schicht erfolgt.

Bevorzugt ist für das erfindungsgemäße Verfahren, dass wenigstens eine der Trennschichten eine plasmapolymere Schicht ist.

Der Vorteil an plasmapolymeren Schichten ist, dass sie konturnachbildend aufgetragen werden können, somit optimal die Oberfläche der aktiven Seite eines Wafers schützen können und in ihren Hafteigenschaften optimal auf die Trennanforderungen eingestellt werden können.

Weiter bevorzugt ist ein erfindungsgemäßes Verfahren, bei dem das Schichtsystem, das im Schritt a) bereitgestellt wird, zwischen dem ersten Träger und dem Wafer eine Schicht aus einem ausgehärteten, teilausgehärteten oder aushärtbaren Elastomermaterial umfasst.

Dieses Elastomermaterial besitzt Vorteile insbesondere beim Verbinden der (möglicherweise strukturierten) Waferoberfläche, auf die gegebenenfalls eine (plasmapolymere) Trennschicht aufgetragen sein kann, mit einem starren, gegebenenfalls ebenen ersten Träger.

Dementsprechend ist besonders bevorzugt ein erfindungsgemäßes Verfahren zum Abtrennen eines Wafers, wobei das Schichtsystem die folgenden Schichten in der angegebenen Reihenfolge umfasst: Einen ersten Träger, eine Schicht aus Elastomermaterial wie oben beschrieben, eine plasmapolymere Trennschicht, einen Wafer und einen zweiten Träger.

Ein solches Schichtsystem ist in der bereits oben genannten WO 2007/099146 beschrieben, die vollumfänglich auf dem Wege der Verweisung Bestandteil dieser Anmeldung wird. Insbesondere Bestandteil dieser Anmeldung werden die Teile, die die Ausgestaltung der Trennschicht und der Elastomerschicht beschreiben. Ebenfalls auf dem Wege der Verweisung wird Bestandteil dieser Anmeldung die WO 2004/051708, die ebenfalls Angaben über geeignete Trennschichten enthält. Insbesondere diese Angaben werden auf dem Wege der Verweisung Bestandteil dieser Anmeldung.

Erfindungsgemäß bevorzugt kann auch - wie bereits oben angedeutet - ein Verfahren sein, wobei das Schichtsystem zwischen dem ersten Träger und in der Schicht aus einem ausgehärteten, teilausgehärteten oder aushärtbaren Elastomermaterial eine zweite Trennschicht enthält. Mittels dieser zweiten Trennschicht ist es möglich, den ersten Träger von dem nach dem Trennen verbleibenden (Rest-) Schichtsystem zu befreien, so dass der erste Träger leicht wieder verwendet werden kann.

Bevorzugt ist ein erfindungsgemäßes Verfahren, wobei das Schichtsystem eine wie oben beschriebene Trennschicht umfasst und zwischen einer der beiden Oberflächen der Trennschicht und der an diese Oberfläche angrenzenden Oberfläche (einer weiteren Schicht oder des Wafers) eine geringere Haftkraft als in allen anderen Schichten und zwischen allen anderen aneinander angrenzenden Schichten des Schichtsystems vorliegt.

Auf diese Weise ist die Trennebene, die während des Trennvorganges bevorzugt ausgenutzt wird, vorgegeben.

Erfindungsgemäß bevorzugt ist es auch, den ersten Träger wiederum bevorzugt mittels Unterdruck oder elektrostatischer Aufladung während des Trennvorganges auf einem Haltemittel zu fixieren.

Erfindungsgemäß ebenfalls bevorzugt ist ein Verfahren, bei dem die Trennhilfe eine zumindest teilweise konvexe Oberfläche umfasst oder die Oberfläche der Trennhilfe zumindest teilweise zu einer konvexen Oberfläche verformt werden kann. Bevorzugt ist dabei die (vorhandene) oder beim Verformen eingestellte Krümmung der Oberfläche so angepasst, dass der Wafer beim Ablösen vom ersten Träger nicht bricht. Eine solche Einstellung kann der Fachmann bei der Durchführung des erfindungsgemäßen Verfahrens leicht ermitteln.

Bevorzugt ist für das erfindungsgemäße Verfahren die Oberfläche der Trennhilfe, an die der zweite Träger zumindest während des Trennens fixiert wird, die Oberfläche eines Zylindermantels oder eines Zylinderabschnittes. Dies ist auch dann der Fall, wenn die Trennung mithilfe einer Trennhilfe erfolgt, die im Bereich der Trennfront konvex verformt wird.

Bevorzugt ist ein erfindungsgemäßes Verfahren, wobei die Trennhilfe eine Walze ist und die Walze zum Abtrennen des Wafers vom ersten Träger über die dem Wafer abgewandte Seite des zweiten Trägers gerollt wird und der zweite Träger unmittelbar hinter der Trennfront auf der Walze fixiert wird.

Besonders bevorzugt ist ein erfindungsgemäßes Verfahren, wobei die Trennhilfe eine flexible Platte ist.

In einem besonders bevorzugten erfindungsgemäßen Verfahren wird zum Ablösen des Wafers die flexible Platte durch Anlegen einer Kraft, die mindestens teilweise senkrecht zur Oberfläche der flexiblen Platte wirkt und vom ersten Träger weg gerichtet ist, zumindest teilweise (ab einsetzender Trennung im Bereich der Trennfront) konvex verformt. Dabei wird zunächst nur der Abstand eines Teils der flexiblen Platte vom ersten Träger vergrößert.

Bevorzugt ist ein erfindungsgemäßes Verfahren, wobei der erste Träger auf einem Haltemittel fixiert ist, als Trennhilfe eine flexible Platte eingesetzt wird und das Haltemittel und die flexible Platte je mindestens eine Ausformung haben und die das Trennen (und das Verformen der flexiblen Platte) bewirkende Kraft zwischen mindestens einer Ausformung der flexiblen Platte und mindestens einer Ausformung des Haltemittel wirkt (beziehungsweise dort angreift).

Dabei sind die Ausformungen im Sinne des zuletzt beschriebenen bevorzugten erfindungsgemäßen Verfahrens bevorzugt Überstände (Vorsprünge), an die die Trennung bewirkende Kraft angelegt werden kann. Bevorzugt ist je eine oder mehrere Ausformungen der flexiblen Platte und/oder der Halterung ein Steg. Besonders bevorzugt ist dabei, dass die Stege so gegenüberliegen, dass zwischen sie eine auseinanderdrückende Kraft angelegt werden kann, die letztlich die Trennung bewirkt.

Bevorzugt ist ein erfindungsgemäßes Verfahren, wobei die Trennhilfe eine optisch transparente Platte ist, da in diesem Falle der Trennvorgang besonders gut optisch überwacht beobachtet werden kann. Besonders geeignet sind hier folgende Materialien: Polymethylmethacrylat (Kurzzeichen PMMA, Handelsnamen Friacryl®, Vitroflex®, Acrylglas Plexiglas®, Limacryl® oder Piacryl) oder auch Polycarbonat (Kurzzeichen PC, Handelsnamen Makrolon, Calibre oder Lexan). Die Auswahl der Materialien für die Trennhilfe nimmt der Fachmann dabei unter Berücksichtigung der Erfordernisse beim Trennen wie Belastung des Wafers oder Anforderungen der Trennvorrichtung vor.

Bevorzugt besitzt die Trennhilfe als Plexiglasplatte eine Dicke von 0,5 - 5 mm, bevorzugt 1 - 4 mm, weiter bevorzugt 2 - 4 mm oder 3 - 4 mm, je nach eingestellter Haftkraft der Trennschicht.

Alternativ oder zusätzlich können in einem erfindungsgemäßen Verfahren die Krümmung der Oberfläche der Trennhilfe auch durch das Anschwellenlassen eines Schwellkörpers bewirkt werden. Ein solcher Schwellkörper muss entsprechend an die Trennhilfe fixiert sein, so dass er die Krümmung bewirken kann. Selbstverständlich kann die Trennhilfe selbst auch ein Schwellkörper sein.

Wie bereits oben angedeutet kann es als alternatives Verfahren auch bevorzugt sein, dass die Trennhilfe gegenüber dem ersten Träger weniger flexibel ausgestaltet ist. In diesem Falle ist es bevorzugt, dass der Trennvorgang durch eine Krümmung des ersten Trägers ausgelöst wird, wobei dieser erste Träger bevorzugt eine Glasplatte oder ein Wafer ist. Ein bevorzugtes Material für die Trennhilfe in diesem Falle eine Sinterplatte. Im Falle dieses alternativ bevorzugten Verfahren ist es selbstverständlich sinnvoll, den ersten Träger nicht zu fixieren oder nur so zu fixieren, dass der (erwünschten) Krümmung die Fixierung nicht entgegen steht.

Bevorzugt ist ein erfindungsgemäßes Verfahren, bei dem der zweite, dehnbare Träger eine Sägefolie (auch als blue tape bezeichnet) ist. Bevorzugte Sägefolien sind in der Industrie standardmäßig verwendete UV-release Tapes, z.B.: Lintec Adwill D.

Eine solche Sägefolie (oder ein vergleichbares Material) wird nach dem Dünnen des Wafers auf dessen Rückseite auflaminiert. Dazu stehen dem Fachmann eine Vielzahl von Möglichkeiten zur Verfügung. Üblicherweise besitzt eine solche Sägefolie eine Seite, die mittels aufgebrachten Klebers auf der Rückseite des Wafers haftet. Die Haftkraft des zweiten Trägers zum Wafer kann bevorzugt mittels thermischer Energie und/oder UV-Strahlung verändert werden, um gegebenenfalls auch den zweiten Träger vom Wafer wieder zu entfernen. Sägefolien (als zweite Träger) mit solchen Klebern werden auch als "Thermorelease-Folien" bzw. "UV-Release-Folien" bezeichnet.

Sägefolien sind dehnbar im Sinne der hier vorliegenden Anmeldung.

Üblicherweise und bevorzugt auch für erfindungsgemäß bevorzugt Verfahren reicht die Sägefolie beim Auflaminieren über den Rand des Wafers bzw. des zu trennenden Schichtsystems hinaus und wird an ihrem Rand mittels eines Ringes gehalten. Dieser Ring, der aus Metall oder einem Kunststoff bestehen kann, wird gewöhnlich Sägerahmen oder "Dicing Frame" genannt. Der Rahmen bildet zusammen mit der Folie eine Art Trommel, deren Membran der zweite Träger ist und wobei der Rest des Schichtsystems beginnend mit der Rückseite des Wafers auf dieser Membran (Sägefolie) aufliegt.

In einem besonders bevorzugten erfindungsgemäßen Verfahren wird nun das die Sägefolie umfassende Schichtsystem in eine Vorrichtung gebracht, in der der erste Träger auf einem Chuck (bevorzugt mittels Unterdruck) fixiert wird.

Nun wird auf der freiliegenden Rückseite der Sägefolie (zweiter Träger) ein weiterer Chuck, wiederum vorzugsweise mittels unter Unterdruck fixiert. Beide Chucks sind dabei bevorzugt so positioniert, dass sie zueinander lateral in der Draufsicht von oben in Deckung sind. Wenn er für die Durchführung der Variante i) verwendet wird ist der Chuck, an dem jetzt die Sägefolie fixiert ist, bevorzugt aus einem biegbaren (flexiblen) Material hergestellt und in einer Dicke, dass er die Funktion der erfindungsgemäß einzusetzenden Trennhilfe erfüllen kann.

Zur Durchführung des erfindungsgemäßen Verfahrens besitzen die beiden Chucks (Haltemittel und Trennhilfe) bevorzugt zumindest an einer Fläche der Vorrichtung einen Bereich, der über die Fläche des Wafers bzw. des Schichtsystems hinausreicht. Zwischen diesen Bereichen kann nun bei entsprechender Fixierung eine Kraft ausgeübt werden, die dazu führt, dass der die Sägefolie (den zweiten Träger) haltende Chuck (Trennhilfe) an einer Seite von dem anderen Chuck (Haltemittel) entfernt wird. Dadurch biegt sich die Trennhilfe und die gewünschte Trennfront entsteht.

Hierbei ist es sehr gut möglich, die einwirkende Kraft genau zu steuern, so dass der Wafer während des Trennvorganges nicht zu stark beansprucht wird.

Sofern ein bevorzugtes Verfahren zur Durchführungdes erfindungsgemäßen Verfahrens mit einer Trennschicht und/oder dem weiteren oben beschriebenen bevorzugten Schichtsystem durchgeführt wird, ist es möglich, eine saubere Abtrennung auch sehr stark gedünnter Wafer ohne zu große mechanische Belastung (Bruch) zu gewährleisten. Es ist auch möglich, die eingebrachte Kraft zu messen und/oder dabei nachzusteuern, so dass eine Maximalkraft nicht überschritten wird. Ebenfalls ist es möglich, mittels der Kraft einen fixen Abstand der beiden Punkte/Linien/Flächen, an denen die Kraft angreift, einzustellen. Dadurch erzeugt eine ursprünglich ebene, aber biegbare Trennhilfe aufgrund ihrer Verformung eine fortlaufende Trennfront, da die Verformung der Trennhilfe sich flächig fortpflanzt, solange bis eine vollständige Trennung erfolgt ist und die Trennhilfe wiederum ihre Ursprungsform einnehmen kann.

Wie bereits oben beschrieben, sollen die beiden Träger mittels Unterdrucks fixiert werden, es gibt aber grundsätzlich auch weitere Möglichkeiten, wie z.B. eine Fixierung mittels Klebstoffen.

Sofern ein Sägerahmen bei einem erfindungsgemäßen Trennverfahren eingesetzt wird, ist der Sägerahmen bevorzugt so ausgestaltet, dass sich die Oberflächenkrümmung der Trennhilfe auch auf den Sägerahmen übertragen kann. Damit folgen Sägerahmen und eingespannte Sägefolie der Krümmung im Bereich der Trennfront, wobei sie erfindungsgemäß unmittelbar hinter der Trennfront an der Trennhilfe fixiert sind. Der Wafer wiederum folgt der Biegung (Krümmung) der Sägefolie (zweiter Träger), so dass eine Scherkraft zwischen dem Wafer und dem ersten Träger entsteht.

Wie bereits oben angedeutet ist ein Vorteil an dem erfindungsgemäßen Verfahren insbesondere in seinen bevorzugten Ausgestaltungsformen, dass die Trennfront eine verhältnismäßig große Fläche darstellt, so dass die Scherkräfte senkrecht zur Waferoberfläche gering gehalten werden können.

Ohne auf eine Theorie festgelegt zu sein, entsteht aufgrund des erfindungsgemäßen Verfahrens ein Kraftverteilungsgradient innerhalb der Trennfront (d.h. ein Kraftverteilungsgradient senkrecht zur Linie der eigentlichen Trennung (dem Ende der Trennfront), also der Linie, wo die Haftkraft zwischen den zu trennenden Flächen 0 ist), wobei die Tiefe der Trennfront (und damit das Gradientengefälle) im Rahmen des erfindungsgemäßen Verfahrens optimal gesteuert werden kann, so dass die mechanische Belastung gegebenenfalls sehr dünnen Wafers so gering wie möglich gehalten werden kann.

Ein besonders bevorzugtes erfindungsgemäßes Verfahren ein solches, wobei das Schichtsystem die folgenden Schichten in der angegebenen Reihenfolge umfasst:

- einen ersten Träger bestehend aus einer Glasplatte oder einem Wafer,
- eine Schicht aus Elastomermaterial wie weiter oben beschrieben,
- eine plasmapolymere Trennschicht, wie weiter oben beschrieben
- einen Wafer und
- eine Sägefolie als zweiten Träger.

Ebenfalls besonders bevorzugt ist ein erfindungsgemäßes Verfahren, wobei das Schichtsystem die folgenden Schichten in der angegebenen Reihenfolge umfasst:

- einen ersten Träger bestehend aus einer Glasplatte oder einem Wafer,
- eine zweite Trennschicht,
- eine Schicht aus Elastomermaterial, wie weiter oben beschrieben,
- eine plasmapolymere Trennschicht, wie weiter oben beschrieben,
- einen Wafer und

- eine Sägefolie als zweiten Träger.

Bevorzugter Bestandteil der Erfindung ist auch die Verwendung einer Plexiglasplatte, die so eingerichtet ist, dass mittels Unterdrucks ein wie oben beschriebener zweiter Träger an ihr fixiert werden kann, als Trennhilfe beim mechanischen Trennen eines Schichtverbundes (umfassend den zweiten Träger und einen Wafer) von einem ersten Träger. Dabei ist selbstverständlich für die erfindungsgemäße Verwendung das Schichtsystem umfassend den Schichtverbund und den ersten Träger bevorzugt wie für eines der oben beschriebenen bevorzugten Verfahren ausgestaltet.

Teil der Erfindung ist auch eine Vorrichtung, die eingerichtet ist zur Durchführung des erfindungsgemäßen Verfahrens. Insbesondere umfasst eine solche Vorrichtung ein Mittel zum Fixieren des ersten Trägers sowie eine Trennhilfe, wie sie oben beschrieben ist. Diese Trennhilfe dient gleichzeitig als Mittel zum Fixieren des zweiten Trägers. Weiter bevorzugt umfasst eine erfindungsgemäße Vorrichtung Mittel, zum Bewirken der Fixierung mittels elektrostatischer oder Unterdruckkraft, ein Haltemittel zum Fixieren des ersten Trägers und bevorzugt ein Mittel, mittels dessen eine Kraft nur auf einen Teil der Trennhilfe ausgeübt werden kann, so dass die Kraft bewirkt, dass die Trennhilfe eine konvexe Krümmung weg vom ersten Träger erfährt.

Bevorzugt ist als Trennhilfe ein Chuck, der aus einer Plexiglasplatte besteht und der weiter bevorzugt mit Unterdruck beaufschlagt werden kann.

Es können aber auch erfindungsgemäß alle drei Trennvarianten (i), ii) und iii)) oder Variante i) mit ii) oder Variante i) mit iii) jeweils gleichzeitig und/oder zeitversetzt angewendet werden.

Vollständige Trennung bedeutet dabei nicht notwendigerweise, dass Schichtverbund und erster Träger räumlich voneinander getrennt werden. Vielmehr kann es nötig sein, dass Schichtverbund und Trägerverbund während der Trennung durch Haltevorrichtungen, wie zum Beispiel die vorstehend beschriebenen Chucks, in ihren Positionen gehalten werden, um eine vollständige Trennung durch Vibration und/oder Temperaturänderung zu ermöglichen. Hierdurch kann zum Beispiel ein guter mechanischer oder thermischer Kontakt gewährleistet werden.

Trennen bedeutet in diesem Fall das Beseitigen der Haftkraft wenigstens zwischen zwei Schichten des Schichtsystems (wobei Wafer und erster Träger in diesem Sinne ebenfalls als Schichten aufzufassen sind).

In einer bevorzugten Ausführungsform des erfindungsgemäßen Verfahrens wird Variante ii) in Kombination mit der Varianten i) oder in Kombination mit Variante i) und Variante iii) eingesetzt. Zum Erzeugen der Vibrationen können dabei beliebige dazu geeignete Vorrichtungen zur Vibrationserzeugung verwendet werden. Bevorzugt ist die Verwendung von Ultraschall-Aktoren. Besonders bevorzugt ist die Verwendung von Piezo-Keramiken.

In einer bevorzugten Ausführungsform des erfindungsgemäßen Verfahrens wird in Schritt ii) die Vibration durch direkten mechanischen Kontakt von der Vorrichtung zur Vibrationserzeugung auf das Schichtsystem übertragen. Die Vorrichtung zur Vibrationserzeugung kann dabei zum Beispiel auch bereits in einer der oben erwähnten Haltevorrichtungen enthalten oder damit verbunden sein. Bevorzugt wird die Vibration durch direkten mechanischen Kontakt von Festkörpern übertragen. Dies kann zum Beispiel dadurch geschehen, dass die Haltevorrichtungen oder Chucks, wie vorstehend beschrieben, den ersten Träger und/oder den zweiten Träger durch elektrostatische Aufladung oder Vakuum fixieren. Bevorzugt erzeugen oder übertragen die Chucks ihrerseits dabei die Schwingungen auf den ersten Träger und/oder den zweiten Träger.

Es kann ebenfalls bevorzugt sein, wenn die Vibration durch eine Flüssigkeit, bevorzugt Wasser, bevorzugt durch einen Flüssigkeitsfilm und besonders bevorzugt einen Wasserfilm übertragen wird.

Es ist besonders bevorzugt, wenn die Vibration von der Vorrichtung zur Vibrationserzeugung auf den ersten Träger übertragen wird. Ebenfalls Teil der vorliegenden Erfindung ist ein Verfahren bei dem die Vibration von der Vorrichtung zur Vibrationserzeugung auf den Wafer zu übertragen. Das darf im Sinne der Erfindung jedoch nicht zur Beschädigung des Wafers führen.

Bevorzugt ist ein erfindungsgemäßes Verfahren, in dem die Vibration die Frequenz der Eigenfrequenz zumindest einer der Schichten des Schichtsystems ist. Die Eigenfrequenz einer unendlich ausgedehnten Platte berechnet sich nach Formel I:

$$f_n = \frac{n}{2\,d} \sqrt{\frac{E}{\rho}}$$

wobei n = 1, d die Dicke der Platte, E das Young Modulus und $\rho$ die Dichte des Plattenmaterials sind. Für n= 2, 3 bis unendlich erhält man die entsprechenden Oberschwingungen. In Tabelle 1 sind exemplarisch die nach dieser Formel berechneten Eigenfrequenzen und einige Oberschwingungen für Platten aus Glas, Aluminium, Silizium und Silicon angegeben, wie sie üblicherweise in der Wafertechnologie und auch im Verfahren gemäß der vorliegenden Erfindung verwendet werden. Silizium wird als Wafermaterial und als Material für Träger verwendet. Glas und Aluminium werden ebenfalls als Träger verwendet. Silikon ist zum Beispiel als Material für die vorstehend beschriebenen Elastomerschichten geeignet.

Tabelle I

| Material | Dicke | Young Modulus | Schallgeschwindigkeit | Dicke | n = 1 Eigenfrequenz | n = 2 Eigenfrequenz | n = 3 Eigenfrequenz | n = 4 Eigenfrequenz |
|---|---|---|---|---|---|---|---|---|
| | kg/dm$^3$ | MPa | m/s | $\mu$m | kHz | kHz | kHz | kHz |
| | | | | | | | | |
| Silikon | 1,2 | 6 | 71 | 100 | 354 | 707 | 1.061 | 1.414 |
| Silikon | 1,2 | 6 | 71 | 130 | 272 | 544 | 816 | 1.088 |
| Silikon | 1,2 | 6 | 71 | 150 | 236 | 471 | 707 | 943 |
| | | | | | | - | - | - |
| Glas | 2,5 | 60.000 | 4.899 | 600 | 4.082 | 8.165 | 12.247 | 16.330 |
| | | | | | | - | - | - |
| Silizium | 2,3 | 110.000 | 6.871 | 50 | 68.710 | 137.420 | 206.129 | 274.839 |
| | | | | | | - | - | - |
| Aluminium | 2,7 | 113.000 | 6.469 | 6.700 | 483 | 966 | 1.448 | 1.931 |
| Aluminium | 2,7 | 113.000 | 6.469 | 10.000 | 323 | 647 | 970 | 1.294 |
| Aluminium | 2,7 | 113.000 | 6.469 | 15.000 | 216 | 431 | 647 | 863 |
| Aluminium | 2,7 | 113.000 | 6.469 | 2.500 | 1.294 | 2.588 | 3.882 | 5.175 |
| Aluminium | 2,7 | 113.000 | 6.469 | 9.700 | 333 | 667 | 1.000 | 1.334 |

Auch wenn Formel I nur Näherungswerte für die Eigenfrequenzen liefert, so lässt sich aus der Tabelle ablesen, dass die Eigenfrequenz eines gedünnten Wafers von 50 μm zumindest eine Zehnerpotenz über der Eigenfrequenz aller anderen Schichten liegt. Es ist daher in der Regel möglich, die anderen Schichten des Schichtsystems in ihrer Eigenfrequenz zum Schwingen zu bringen ohne Silizium zu starken Schwingungen anzuregen.

Bevorzugt ist daher ein erfindungsgemäßes Verfahren, worin in Schritt ii) eine der Schichten des Schichtsystems zum Schwingen in ihrer Eigenfrequenz angeregt wird. Besonders bevorzugt ist ein solches erfindungsgemäßes Verfahren, worin die zum Schwingen in ihrer Eigenfrequenz angeregte Schicht nicht der Wafer ist. Am meisten bevorzugt ist ein solches erfindungsgemäßes Verfahren, worin die zum Schwingen in ihrer Eigenfrequenz angeregte Schicht der erste Träger ist.

Bevorzugt ist ebenfalls ein erfindungsgemäßes Verfahren, worin in Schritt ii) eine der Schichten des Schichtsystems zum Schwingen in ihrer Eigenfrequenz angeregt wird und wobei das im Schritt a) bereitgestellte Schichtsystem zwischen dem Wafer und dem ersten Träger wenigsten eine weitere Schicht aufweist.

Tabelle I zeigt, dass die Eigenfrequenz einer Glasplatte sich deutlich von der Eigenfrequenz einer Elastomerschicht unterscheiden kann. Wird im erfindungsgemäßen Verfahren als Träger eine Glasplatte in der angegebenen Stärke verwendet, auf der eine Elastomerschicht aufgebracht ist, so kann die Glasplatte zu Schwingungen in Ihrer Eigenfrequenz angeregt werden. Die Elastomerschicht würde dabei lediglich in etwa ihrer zwölften Oberschwingung angeregt werden. Die Elastomerschicht würde also im wesentlichen nicht mitschwingen. Dadurch entstehen zwischen der Glasplatte und der Elastomerschicht mechanische Spannungen, die zur Trennung an der Grenzfläche zwischen Glasplatte und Elastomerschicht führen können. Gleichzeitig dämpft die Elastomerschicht die Vibrationen, die somit nur abgeschwächt auf den Wafer übertragen werden.

Bevorzugt ist daher ein erfindungsgemäßes Verfahren, worin in Schritt ii) der erste Träger des Schichtsystems zum Schwingen in seiner Eigenfrequenz angeregt wird.

Besonders bevorzugt ist ein solches erfindungsgemäße Verfahren bei dem das Schichtsystem, das im Schritt a) bereitgestellt wird, zwischen dem ersten Träger und dem Wafer eine Schicht aus einem ausgehärteten, teilausgehärteten oder aushärtbarem Elastomermaterial umfasst, wie vorstehend umschrieben. Es ist dabei erfindungsgemäß bevorzugt, wenn der erste Träger aus Glas besteht. Es kann dabei im Sinne der Erfindung bevorzugt sein, dass die Trennung zwischen dem ersten Träger und der Elastomerschicht erfolgt.

Eine solche Trennung die nicht an der Oberfläche des Wafers erfolgt ist vor allem dann vorteilhaft, wenn die dem ersten Träger zugewandte Seite des Wafers so strukturiert ist, dass eine mechanische Trennung wegen des Formschlusses zwischen der Waferoberfläche und der daran angrenzenden Oberfläche des Trägersystems ohne Zerstörung des Wafers nur schwer möglich ist. Dies gilt für alle Schritte i), ii) und iii) des Verfahrens. Die nach dem Trennen eventuell verbleibenden (Rest-) Schichten des Schichtverbundes (wie vorstehend beschrieben) können dann auf geeignete Weise, wie zum Beispiel durch Peeling oder ähnlichem vom Wafer entfernt werden.

Ähnliche Überlegungen wie für die Elastomerschicht gelten auch für die Trennschicht wie vorstehend beschrieben und andere Schichten des Trägerverbundes.

Tabelle I zeigt am Beispiel von Aluminium, dass die Eigenfrequenz des ersten Trägers variiert werden kann. Wird als erster Träger Aluminium eingesetzt oder wird der erste Träger mit Aluminium oder anderen Materialien so verbunden, dass sich ein gemeinsames Schwingsystem (ein schwingfähiges System) ergibt, so kann die Eigenfrequenz des ersten Trägers so eingestellt werden, dass sie der Eigenfrequenz der Elastomerschicht oder auch der Trennschicht entspricht oder so, dass der erste Träger je nach Bedarf gut anregbar ist, aber seine Eigenfrequenz (bzw. die Eigenfrequenz seines Schwingsystems) so über der Eigenfrequenz der Elastomerschicht liegt, dass diese bei Anregung des ersten Trägers im Bereich von dessen Eigenfrequenz eben nicht mitschwingt. Durch eine entsprechende Auswahl der Schichten des Trägerverbundes (bzw. Schwingsystems) kann die Vibration auf die Grenzfläche zum Wafer übertragen werden und die Trennung von Trägerverbund und Wafer erfolgt zwischen der Oberfläche des Wafers und der daran angrenzenden Oberfläche des Trägerverbundes. Hierbei sei angemerkt, dass die bevorzugten plasmapolymeren Trennschichten so eingestellt sind, dass sie in ihrem Schwingverhalten der elastomeren Schicht entsprechen oder mit dieser gemeinsam ein Schwingsystem bilden.

Bevorzugt ist daher ein erfindungsgemäßes Verfahren, worin in Schritt ii) die Schicht des Trägerverbundes die direkt an den Wafer angrenzt zum Schwingen in ihrer Eigenfrequenz angeregt wird. Besonders bevorzugt ist ein solches erfindungsgemäßes Verfahren in dem die Trennung von Trägerverbund und Wafer zwischen der Oberfläche des Wafers und der daran angrenzenden Oberfläche des Trägerverbundes erfolgt.

In einer weiteren bevorzugten Ausführungsform des erfindungsgemäßen Verfahrens wird Variante iii) in Kombination mit der Variante i) oder in Kombination mit Variante i) und Variante ii) eingesetzt. Dabei wird im Schichtsystem durch Veränderung der Temperatur des Schichtsystems oder von Teilen des Schichtsystems eine mechanische Spannung erzeugt die zur Trennung von erstem Träger und Wafer (und damit von Trägerverbund und Schichtverbund) führt oder zu dieser beiträgt.

Die Trennung von Schichten eines Schichtsystems in Kombination mit einer Temperaturveränderung gemäß dem erfindungsgemäßen Verfahren beruht ausschließlich oder im Wesentlichen auf den unterschiedlichen Wärmeausdehnungskoeffizienten für die verschiedenen Materialien der einzelnen Schichten des Schichtsystems, wie zum Beispiel erster Träger, zweite Trennschicht, Elastomerschicht, Trennschicht und Wafer. Bei Temperaturveränderung innerhalb der Schichten entstehen Kräfte, wodurch sich die Schichten in Richtung der Ebenen der Oberflächen verschieden stark ausdehnen sollten. Eine seitliche Ausdehnung der Schichten ist dagegen wegen der Haftkraft zwischen den Schichten untereinander bzw. zum ersten Träger und zum Wafer nur eingeschränkt oder nicht möglich. Zwischen den Oberflächen der Schichten werden auf diese Weise starke Scherkräfte erzeugt die zur Trennung der Schichten zwischen den Oberflächen von zwei aneinander angrenzenden Schichten führen können.

Bevorzugt ist deshalb ein Verfahren wie vorstehend beschreiben, bei dem im Schichtsystem eine Schicht (einschließlich des Wafers und des ersten Trägers) enthalten ist deren Wärmeausdehnungskoeffizient jeweils wenigstens um den Faktor 2, bevorzugt 4, besonders bevorzugt 6 und ganz besonders bevorzugt 10 von dem Wärmeausdehnungskoeffizienten einer beliebigen anderen Schicht des Schichtsystems unterscheidet. Hierbei werden allerdings keine Schichten einbezogen, die auf der dem ersten Träger abgewandten Seite des Wafers vorgesehen sind. Ebenfalls bevorzugt ist ein erfindungsgemäßes Verfahren, bei dem zwei benachbarte Schichten des Schichtsystems die genannten unterschiedliche Wärmeausdehnungskoeffizienten haben.

Natürlich können Temperaturveränderungen auch zu Änderungen in den physikalischen Eigenschaften oder der chemischen Strukturen der Schichtmaterialien führen. Trennmethoden die im Wesentlichen darauf beruhen, dass die Bindungskräfte zwischen den Schichten des Schichtsystems oder innerhalb der Schichten durch Änderungen des Aggregatzustands der Schichtmaterialien von festen Stoffen zu flüssigen, gelartigen oder gasförmigen Stoffen vollständig oder im Wesentlichen aufgehoben werden sind ausdrücklich nicht Gegenstand der vorliegenden Erfindung.

Gegenstand der vorliegenden Erfindung sind jedoch auch Verfahren, in denen ein Teil eines Feststoffes der Teil eines Schichtmaterials ist in den flüssigen, gelartigen oder gasförmigen Zustand übergeht. Dabei dürfen jedoch nicht mehr als 10 Gew.-%, bevorzugt nicht mehr als 5 Gew.-%, besonders bevorzugt nicht mehr als 1 Gew.-% und am meisten bevorzugt nicht mehr als 0,1 Gew.-% des Schichtmaterials jeder der Schichten zwischen denen oder in denen die Trennung erfolgt vom festen in den flüssigen, gelartigen oder gasförmigen Zustand übergehen.

Das Verfahren gemäß der vorliegenden Erfindung beruht darauf, dass durch die Merkmale des Anspruches 1 die Trennung dadurch geschieht, dass der Haftkraft, die die Schichten zusammen hält, eine Kraft entgegengesetzt wird, die diese Kraft überwindet (mechanische Trennung).

Zum Erwärmen können beliebige dazu geeignete Vorrichtungen verwendet werden. Bevorzugt wird das gesamte Schichtsystem erwärmt.

Wie oben beschrieben besteht der erste Träger bevorzugt aus festen Materialien. Ein direkter Kontakt des Trägers mit dem Wafer könnte bei der Einwirkung von Scherkräften durch die harten Oberfläche des ersten Trägers zu Beschädigungen am Wafer führen. In einem bevorzugten erfindungsgemäßen Verfahren befindet sich - wie oben beschrieben - im Schichtsystem zwischen dem ersten Träger und dem Wafer deshalb mindestens eine weitere Schicht, bevorzugt mindestens eine Elastomerschicht und/oder eine Trennschicht. Elastomerschichten haben in der Regel Wärmeausdehnungskoeffizienten, die deutlich verschieden sind von den Wärmeausdehnungskoeffizient von Silizium. Darüber hinaus kann der Wärmeausdehnungskoeffizient durch geeignete Materialauswahl variiert werden. In einem bevorzugten erfindungsgemäßen Verfahren befindet sich daher zwischen dem ersten Träger und dem Wafer mindestens eine Elastomerschicht.

In einem bevorzugten erfindungsgemäßen Verfahren befindet sich zwischen dem ersten Träger und dem Wafer mindestens eine Schicht die vollständig oder teilweise aus einem Silikonelastomeren besteht. Silikonelastomeren zeichnen sich dadurch aus, dass sie Ihre mechanischen Eigenschaften, insbesondere ihre Festigkeit und Härte bei Temperaturänderungen nur in besonders geringfügigem Maße ändern und deshalb auch bei hohen Temperaturen, wie sie für den Trennvorgang unter Umständen notwendig sind noch genügend Festigkeit besitzen um die durch Scherung entstehenden Kräfte aufrecht zu erhalten. Materialien die bei Temperaturerhöhung zu sehr erweichen, würden die Scherkräfte durch Verformung absorbieren und neutralisieren. Der Wärmeausdehnungskoeffizient von Silikonelastomeren liegt um etwa eine Zehnerpotenz über der von Silizium und Glas, so dass die Erzeugung von Spannungen und Scherkräften durch Temperaturänderungen zwischen Schichten aus Silikonmaterialien und Silizium- und Glasschichten besonders effektiv ist.

Weiterhin bevorzugt ist ein erfindungsgemäßes Verfahren bei dem sich zwischen erstem Träger und Wafer mindestens eine Trennschicht befindet. Wie oben beschrieben verleiht die Trennschicht dem Schichtsystem eine Sollbruchstelle, an der geringe Haftkräfte wirken und die deshalb eine leichte Trennung ermöglicht. Dies ist auch bei der Durchführung der Variante iii) eine vorteilhafte Ausführungsform. Besonders bevorzugt ist ein erfindungsgemäßes Verfahren bei dem sich zwischen erstem Träger und Wafer mindestens eine Elastomerschicht und eine Trennschicht befindet. Hierbei kann die Elastomerschicht zur Erzeugung der Scherkräfte und die Trennschicht als Sollbruchstelle dienen. Es ist dabei am meisten bevorzugt, wenn die Schichten des Schichtsystems in der Reihenfolge erster Träger, Elastomerschicht, Trennschicht und Wafer angeordnet sind, wie vorstehend beschrieben. Dabei ist die Trennschicht bevorzugt eine plasmapolymere Schicht, wie oben beschrieben, die wiederum bevorzugt ein der Elastomerschicht ähnliches Wärmeausdehnungsverhalten besitzt.

Weiterhin bevorzugt ist ein erfindungsgemäßes Verfahren bei dem sich zwischen erstem Träger und Wafer mindestens zwei Trennschichten befinden. Besonders bevorzugt ist ein erfindungsgemäßes Verfahren bei dem sich zwischen erstem Träger und Wafer eine Elastomerschicht und zwei Trennschichten befindet. Dabei ist es am meisten bevorzugt, wenn die Schichten des Schichtsystems in der Reihenfolge erster Träger, zweite Trennschicht, Elastomerschicht, Trennschicht und Wafer angeordnet sind, wie vorstehend beschrieben.

Bei einer solchen Anordnung kann die Trennung von erstem Träger und Wafer (von Trägerverbund und Schichtverbund) an der Trennschicht oder an der zweiten Trennschicht erfolgen. Es ist ferner bevorzugt, wenn bei dieser Anordnung die Elastomerschicht bei der Trennung nach Variante iii) die Erzeugung der Scherkräfte bewirkt. Die Trennschichten dienen dabei nicht nur, wie vorstehend als Sollbruchstellen, sondern sorgen auch dafür, dass die eventuell verbleibenden (Rest-) Schichten (wie vorstehend beschrieben) leicht von Wafer und/oder Träger entfernt werden können.

Bei der Bearbeitung von Wafern werden die eingesetzten Schichten häufig großen Temperaturänderungen ausgesetzt. Es ist daher wichtig, dass die Schichtsysteme nicht delaminieren und so schon während der Bearbeitung der Wafer zu einer Trennung von erstem Träger und Wafer führen. Da, wie vorstehend beschreiben, Elastomerschichten den Schichtverbund bei Temperaturänderungen besonders großen Spannungen und Scherkräften aussetzen, müssen entsprechende Vorkehrungen getroffen werden, um eine Trennung von erstem Träger und Wafer während der Bearbeitung zu unterbinden.

Bevorzugt ist daher ein erfindungsgemäßes Verfahren, wobei das im Schritt a) bereitgestellte Schichtsystem mindestens eine Elastomerschicht enthält und so hergestellt worden ist, dass im Schichtsystem bei genau einer Temperatur zwischen 20°C bis 200°C keine mechanischen Spannungen zwischen den Oberflächen der elastomeren Schicht (4) und den daran angrenzenden Oberflächen auftreten und die elastomere Schicht ausgehärtet ist.

Die bevorzugte Methode um diesen Zustand zu erreichen ist das Aushärten des Elastomers zwischen den benachbarten Schichten des Schichtverbunds, bei der Temperatur, bei der die Spannungsfreiheit bestehen soll. Die Temperatur wird dabei vorzugsweise so gewählt, dass der Schichtverbund bei allen angewandten Bearbeitungstemperaturen erhalten bleibt. Insbesondere sollte der Schichtverbund bei Raumtemperatur stabil bleiben. Die Aushärtungstemperatur ist materialabhängig, so dass der Fachmann um eine gewünschte Temperatur zu erreichen, bei der die genannte Spannungsfreiheit besteht, das Elastomermaterial entsprechend modifizieren wird.

Bevorzugt ist ein daher erfindungsgemäßes Verfahren nach Anspruch 1, worin die Trennung

iii a.) durch Erwärmen des Schichtsystems oder Teilen davon auf Temperaturen, die wenigstens 100°C, bevorzugt 150°C oberhalb der Temperatur bei der keine mechanischen Spannungen zwischen den Oberflächen der elastomeren Schicht (4) und den daran angrenzenden Oberflächen auftreten, liegen oder

iii b.) durch Abkühlen des Schichtsystems oder Teilen davon auf Temperaturen, die wenigstens 100 °C, bevorzugt 150 °C unterhalb der Temperatur bei der keine mechanischen Spannungen zwischen den Oberflächen der elastomeren Schicht (4) und den daran angrenzenden Oberflächen auftreten, liegen, unterstützt wird.

Dies führt dazu, dass die Temperatur bei der die Trennung vorgenommen wird genügend verschieden von den Temperaturen ist, bei der der Wafer bearbeitet wird.

Bevorzugt ist ein ebenfalls erfindungsgemäßes Verfahren, wobei das im Schritt a) bereitgestellte Schichtsystem mindestens eine Elastomerschicht enthaltend oder bestehend aus Silikon enthält, welche in einem Bereich von 80 °C bis 220 °C, bevorzugt in einem Bereich von 120 °C bis 180 °C zwischen den Schichten des Schichtsystems ausgehärtet worden ist, wobei die Trennung bei Temperaturen im Bereich von 200 °C bis 400 °C, bevorzugt im Bereich von 250 °C bis 350 °C durchgeführt wird.

Nachfolgend wird die Erfindung anhand von Zeichnungen und anhand eines Beispieles näher erläutert. Zeichnungen und Beispiele dienen aber nicht dazu, die Erfindung einzuschränken.

Fig. 1 stellt ein zu trennendes Schichtsystem dar, umfassend einen Wafer nach dem Abdünnen.

Fig. 2 stellt ein zu trennendes Schichtsystem dar, das bereits für den Trennvorgang fixiert ist und

Fig. 3 stellt das zu trennende Schichtsystem während des Trennvorgangs dar.

Fig. 4 stellt ein schematische Modell für einen unendlich ausgedehnte schwingende Platte dar.

Fig. 5 stellt schematisch die Längenausdehnung und die dadurch entstehenden Spannungen in einem Körper dar.

Die Bezugszeichen bedeuten im Einzelnen:

| 1 | erster Träger |
|---|---|
| 1 a | Trägerverbund (im gegebenen Beispiel der Figuren 1 bis 3) |
| 2 | elastomere Schicht |
| 3 | Trennschicht |
| 4 | strukturierte Vorderseite des Wafers |
| 5 | Rückseite des Wafers |
| 6 | abzutrennender Teil des Schichtsystems, umfassend den ersten Träger |
| 7 | Wafer (Vorderseite und Rückseite) |
| 8 | Schichtverbund (im gegebenen Beispiel der Figuren 1 bis 3) |
| 18 | haftvermittelnde Seite des zweiten Trägers |
| 19 | zu trennendes Schichtsystem (ohne zweiten Träger) |
| 20 | zweiter Träger |
| 21 | Sägerahmen |
| 28 | Haltemittel zum Fixieren des ersten Trägers |
| 29 | Trennhilfe |
| 30, 31 | Alternativen für Wirkrichtung und Ansatzpunkt für die die Trennung bewirkende Kraft |
| 33 | Trennfront |
| 34 | Ende der Trennfront |
| | |
| a | Kantenlänge des Körpers bzw. Volumenelements |
| a+s | Kantenlänge nach Längenänderung durch Erwärmen |
| d | Dicke der Platte |

Genauere Beschreibung der Figuren

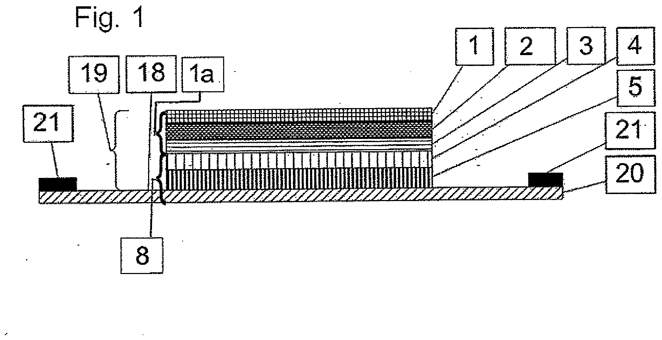

Die Fig. 1 stellt das zu trennende Schichtsystem 19, 20 dar. Dabei ist ein erster Träger 1, der bevorzugt als Glasplatte ausgestaltet ist, mit einer Elastomerschicht 2 verbunden, die ihrerseits wiederum mit einer Trennschicht 3 verbunden ist. Die Trennschicht 3 ist mit der aktiven Vorderseite des Wafers 4, 5 verbunden. Die Haftkraft zwischen der Trennschicht 3 und dem Wafer 4, 5 ist die geringste innerhalb des gesamten Schichtsystems. Auf der Rückseite des Wafers 5 ist der zweite Träger 20 befestigt. Dieser kann als Sägefolie ausgestaltet sein, die in einen Sägerahmen 21 eingespannt ist.

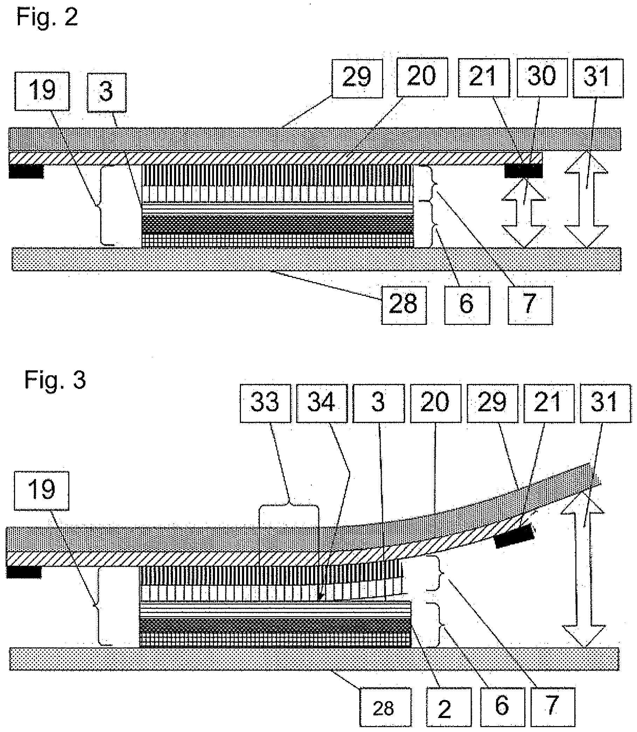

Fig. 2 stellt das zu trennende Schichtsystem 19, 20 im für die Trennung vorbereiteten Zustand dar. Dabei ist der erste Träger auf einem Mittel zum Fixieren des ersten Trägers 28 fixiert. Das abzutrennende Schichtsystem, das den ersten Träger umfasst 6, ist noch vollflächig mit dem Wafer (Vorder- und Rückseite) 7 verbunden. Die Trennhilfe 29 ist flächig mit dem zweiten Träger 20 verbunden und parallel zum zweiten Träger und auch zum ersten Träger ausgerichtet. Die Pfeile 30 und 31 zeigen mögliche Wirkrichtungen und Ansatzpunkte für die die Trennung bewirkende Kraft auf.

Fig. 3 zeigt den Trennvorgang, bei dem gerade das zu trennende Schichtsystem 19, 20 in den abzutrennenden Teil des Schichtsystems, umfassend den ersten Träger 6 und den Schichtverbund 7, 20 getrennt wird. Dieses wird bewirkt durch die im Bereich des Pfeiles 31 angesetzte Kraft, die dazu führt, dass die Trennhilfe 29 einseitig vom Haltemittel zum Fixieren des ersten Trägers 28 und damit auch vom ersten Träger 1 weg bewegt wird. Dabei erfährt die Trennhilfe eine Krümmung. Dieser Krümmung folgt der zweite Träger 20 vollständig und mit ihm auch der Wafer 7. Dadurch entsteht eine Scherwirkung im zu trennenden Schichtsystem 19, die sich im Bereich der Trennfront 33 auswirkt. Am Ende der Trennfront 34 ist die Haftkraft zwischen dem abzutrennenden Teil des Schichtsystems 6 und dem Wafer 0. Dabei wird im vorliegenden Beispiel durch die Trennschicht 3 gewährleistet, dass die Trennebene zwischen dem Wafer 7 und der Trennschicht 3 verläuft.

Durch die flächige Fixierung des zweiten Trägers 20 an der Trennhilfe 29 (auch) unmittelbar angrenzend an die Trennfront 33 ist eine optimale Kraftübertragung gewährleistet: Die auf den Wafer einwirkenden senkrechten Kräfte sind verhältnismäßig gering und im Rahmen eines Gradienten über die Trennfront 33 zunehmend bis zum Ende der Trennfront 34. Dadurch wird insbesondere im Bereich der Trennfront 33 ein virtueller Krümmungswinkel erzeugt, der gegen unendlich geht und somit den Wafer 7 so wenig wie möglich belastet.

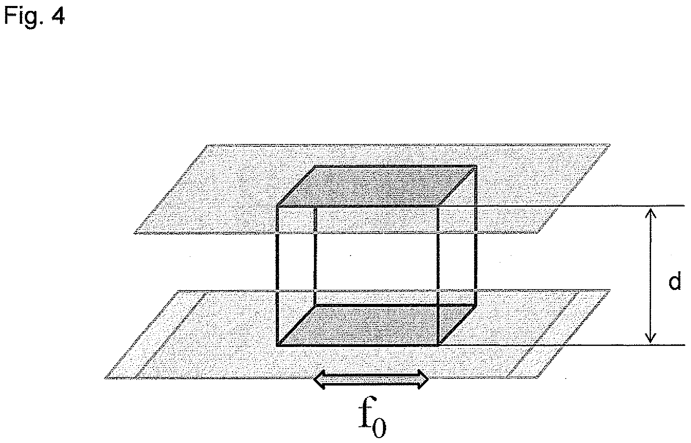

Fig. 4 zeigt das Schwingungssystem, welches Anregung der Eigenfrequenz einer unendlich ausgedehnten Platte vorhanden ist. Es ist eine Modell für die Schwingungen der Schichten im Schichtsystem. Die Eigenfrequenz einer solchen Schicht berechnet sich in erster Näherung nach der Formel

$$f_n = \frac{n}{2\,d} \sqrt{\frac{E}{\rho}}$$

wobei n = 1, d die Dicke der Platte, E das Young Modulus und $\rho$ die Dichte des Plattenmaterials sind. Die Eigenfrequenz hängt also im Wesentlichen nur von den Materialeigenschaften und der Schichtdicke ab.

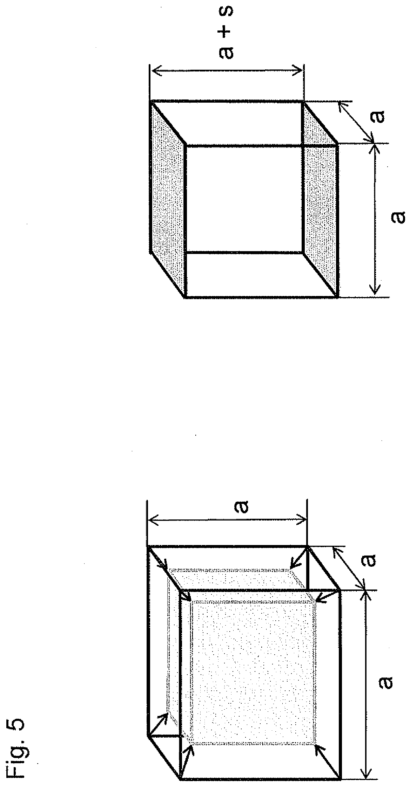

Fig. 5 zeigt das Verhalten eines Volumenelements eine Festkörpers der einer Volumenänderung durch Temperaturänderung ausgesetzt ist. Die linke Abbildung zeigt ein freies Volumenelement, in dem sich das Volumenelement symmetrisch und spannungsfrei verformt. Auf der rechten Seite ist ein Volumenelement gezeigt, welches oben und unten fixiert ist. Dies ist eine vereinfachte Darstellung der Situation einer Schicht in dem erfindungsgemäß einzusetzenden Schichtsystem unter der Annahme, dass sich die Volumina und Grenzflächen der anderen Schichten bei Temperaturänderung nicht verändern. Eine Volumenänderung ist im Wesentlichen nur noch in Richtung senkrecht zu der oberen und unteren Grenzfläche möglich. In Richtung der Grenzfläche treten Spannungen auf, da die fixierten Oberflächen Ihre Längenausdehnung nicht ändern können. Eine Delaminierung an diesen Grenzflächen findet statt, wenn die durch die Spannungen erzeugte Kraft an den Grenzflächen die Haftkraft zwischen den Grenzflächen übersteigt.

**Beispiele:**

Beispiel 1 (Trennung erfindungsgemäß):

Die Vorderseite eines Wafers, also die Seite, auf der sich die elektronischen Bauteile befinden, wird mittels PECVD mit einer plasmapolymeren Trennschicht überzogen. Diese Trennschicht wird hinsichtlich ihrer Haftungseigenschaften so eingestellt, dass sie auf der zum Wafer gerichteten Seite verhältnismäßig geringe Haftung besitzt, während die Adhäsion hoch ist zu der auf der vom Wafer abgewandten Seite nachfolgend aufgetragenen Schicht. Die letztgenannte Schicht ist im vorliegenden Beispiel eine Silikonelastomerschicht, die zunächst auf eine Glasplatte als ersten Träger aufgetragen wird. Nachfolgend wird der Wafer mit der bereits aufgebrachten Trennschicht trennschichtseitig mit der auf die Glasplatte aufgebrachten Elastomerschicht verpresst (gebondet). Es besteht nun ein Schichtsystem umfassend den Wafer, die Trennschicht, die Elastomerschicht und die Glasplatte als Träger.

Das Bonden kann mit typischen aus dem Stand der Technik bekannten Bonden erfolgen. Zu Einzelheiten zur Erstellung des beschriebenen Schichtsystems wird beispielhaft auf die WO 2007/099146 verwiesen.

Nachfolgend wird der Wafer auf seiner freiliegenden Rückseite gedünnt. Das Dünnen erfolgt mittels nach dem Stand der Technik bekannten Verfahren. Dabei wird der Wafer auf eine Dicke von 50 $\mu$m gedünnt. Nach dem Dünnen wird das Schichtsystem, das den Wafer umfasst, in eine Anlage verbracht, in der die Waferrückseite durch Ätzen weiter behandelt wird. Insbesondere dient das Ätzen dazu, Oberflächenbeschädigungen der Waferrückseite, die während des Dünnens entstehen, auszugleichen. Der Ätzvorgang erfolgt nach dem Stand der Technik, z.B. nasschemisch mittels Ätzbades oder trockenchemisch mittels Plasmas. Das Ätzen bewirkt insbesondere, dass Beschädigungen in Form von Ausbrechungen und Rissen vollständig beseitigt werden und der Wafer eine höhere mechanische und thermische Widerstandskraft erhält.

Nachfolgend wird auf das Schichtsystem eine Sägefolie, z.B.: Lintec Adwill D mit ihrer adhäsiven Seite auflaminiert. Nun wurde das Schichtsystem in eine Trennvorrichtung gebracht, in der mittels eines Vakuum-Chucks die Rückseite der Glasplatte so fixiert wird, dass sie sich nicht mehr verschieben lässt.

Auf der Rückseite der Sägefolie wird nun als Trennhilfe ein spezieller Vakuum-Chuck fixiert, der aus einer 3 mm starken Plexiglasplatte besteht.

Nachdem an beiden Vakuum-Chucks das Vakuum aufgebaut ist, wird an einer Seite der Plexiglasplatte eine Kraft senkrecht zur Ebene des Wafers angelegt. Diese Kraft führt dazu, dass die flexible Plexiglasplatte gebogen wird, wobei die Biegung eine Trennfront im Schichtsystem entstehen lässt. Diese Trennfront läuft in der Ebene zwischen der Vorderseite des Wafers und der Trennschicht. Die Biegung der Plexiglasplatte ist dabei gegenüber dem ersten Träger konvex. Während der Wafer und der zweite Träger der fortlaufenden Biegung der Plexiglasplatte (Vakuum-Chuck) folgen, ist dies bei dem Rest des Schichtsystems, der an dem ersten Träger fixiert ist, nicht der Fall. Die dadurch entstehende Scherkraft bewirkt die Trennung des Wafers von der Trennschicht.

Dabei lässt sich die Kraft so einstellen, dass auch sehr dünne Wafer wie im vorliegenden Beispiel von 50 $\mu$m Dicke unbeschadet von dem ersten Träger getrennt werden können. Dies geschieht dadurch, dass die Trennfront mit kontrollierbarer Geschwindigkeit über die gesamte Trennfläche läuft.

Schließlich liegt die Vorderseite des Wafers von dem übrigen Schichtsystem befreit vor. Nach der Trennung kann das Vakuum der beiden Vakuum-Chucks abgeschaltet werden. Nun kann der Wafer laminiert auf einer Sägefolie entnommen werden und weiteren Bearbeitungsschritten, wie z.B. dem Vereinzeln durch Sägen, zugeführt werden.

Beispiel 2 (Trennung gemäß Variante ii) (nicht erfindungsgemäß):

Beispiel 2 wird wie Beispiel 1 (bis zum Beginn der eigentlichen Trennung) durchgeführt, allerdings wird beim Aufbau des Schichtsystems eine zusätzliche plasmapolymere Trennschicht vor Auftrag der Elastomerschicht auf die Glasplatte aufgetragen und hinsichtlich ihrer Haftkraft so eingestellt, dass sie an der Elastomerschicht (nach Fertigstellen des Schichtsystems) fester haftet als an der Glasplatte und dass die Haftkraft zwischen Glasplatte und dieser Trennschicht die geringste zwischen zwei Schichten im Sichtsystem ist. Außerdem wird anstatt der flexiblen Plexiglasscheibe ein normaler Chuck zur Fixierung der Sägefolie verwendet. Auf diesen Chuck werden keine Kräfte ausgeübt, die zur Trennung des Schichtsystems beitragen könnten. Die Glasplatte ist so an den (Aluminium-) Chuck fixiert, dass ein gemeinsames Schwingsystem besteht, das etwa 4 mm dick ist. Dieses wird mit einer Frequenz von 1 MHz angeregt. Nach etwa 10 Minuten ist der Wafer vom Trägerverbund getrennt. Die Trennung erfolgt zwischen der zusätzlichen plasmapolymeren Schicht und der Glasplatte. Der Schichtverbund kann durch einfaches Abheben vom Trägerverbund (Glasplatte) entfernt werden.

Beispiel 3 (Trennung gemäß Variante iii) (nicht erfindungsgemäß):

Variante iii) wird wie Beispiel 1 (bis zum Beginn der eigentlichen Trennung) durchgeführt, jedoch wird auf die Sägefolie und Plexiglasscheibe nicht eingesetzt. Das Bonden bei der Herstellung des Schichtsystems erfolgt bei 150°C, wobei die Elastomerschicht ausgehärtet wird. Danach wird das Schichtsystem auf 20°C gekühlt. Zur Trennung wird das Schichtsystem für 10 Minuten auf 330°C erhitzt. Die Trennung erfolgt zwischen der plasmapolymeren Schicht und dem Wafer. Der Schichtverbund kann durch einfaches Abheben vom Trägerverbund entfernt werden.

**Patentansprüche**

1. Verfahren zum mechanischen Trennen eines Schichtverbundes (8) von einem Trägerverbund (1a) umfassend einen oder bestehend aus einem ersten Träger (1), wobei der Schichtverbund (8) einen Wafer (7) und einen zweiten, dehnbaren Träger (20) umfasst und wobei sich zwischen dem ersten Träger (1) und dem Wafer (7) mindestens eine plasmapolymere Trennschicht (3) befindet, umfassend folgende Schritte:

   a) Bereitstellen eines Schichtsystems (1a, 8) umfassend den Trägerverbund (1a) und den Schichtverbund (8)
   b) Erzeugen einer mechanischen Spannung im Bereich der Grenzfläche zwischen Trägerverbund (1a) und dem Schichtverbund (8), so dass der Schichtverbund (8) vom Trägerverbund (1a) getrennt wird, durch ein Verfahren umfassend

      i) die Schritte:

         i a) Bereitstellen einer Trennhilfe (29),
         i b) Fixieren der Trennhilfe (29) an dem zweiten Träger (20), und
         i c) mechanisches Trennen des Schichtverbundes (8) von dem Trägerverbund (1a) unter Ausnutzen nur genau einer Trennfront (33),

   **dadurch gekennzeichnet, dass** das Fixieren der Trennhilfe (29) an dem zweiten Träger (20) mittels Unterdruck oder elektrostatischer Aufladung so erfolgt, dass während des Trennvorganges der zweite Träger (20) unmittelbar hinter einer beim Trennen entstehenden Trennfront (33) an der Trennhilfe (29) fixiert bleibt.

2. Verfahren nach Anspruch 1, wobei das Trennen in Schritt b) auch durch (ii) Erzeugen einer Vibration im Schichtsystem erfolgt oder unterstützt wird.

3. Verfahren nach einem der Ansprüche 1 oder 2, wobei der Wafer (7) eine Dicke von $\leq 150\ \mu m$, bevorzugt $\leq 80\ \mu m$, besonders bevorzugt von $\leq 20\ \mu m$ und ganz besonders bevorzugt eine Dicke von $\leq 10\ \mu m$ hat.

4. Verfahren nach einem der vorhergehenden Ansprüche, **dadurch gekennzeichnet, dass** das Schichtsystem zwischen dem ersten Träger (1) und dem Wafer (7) eine Schicht (2) aus einem ausgehärteten, teilausgehärteten oder aushärtbaren Elastomermaterial umfasst.

5. Verfahren nach einem der vorhergehenden Ansprüche, wobei das Schichtsystem die folgenden Schichten in der angegebenen Reihenfolge umfasst:

einen ersten Träger (1),
eine Schicht (2) aus Elastomermaterial wie in Anspruch 4 beschrieben,
eine plasmapolymere Trennschicht (3),
einen Wafer (7) und
einen zweiten Träger (20).

6. Verfahren nach einem der Ansprüche 1 bis 5, worin die Trennung zwischen der Oberfläche der plasmapolymeren Trennschicht und der Oberfläche des Wafers erfolgt.

7. Verfahren nach einem der vorhergehenden Ansprüche, wobei die Trennhilfe (29) eine flexible Platte ist.

8. Verfahren nach Anspruch 7, wobei der erste Träger (1) auf einem Haltemittel (28) fixiert ist, die flexible Platte (29) und das Haltemittel (28) je mindestens je eine Ausformung haben und wobei die das Trennen bewirkende Kraft zwischen mindestens einer Ausformung der flexiblen Platte (29) und mindestens einer Ausformung des Haltemittels (28) wirkt.

9. Verfahren nach einem der Ansprüche 7 oder 8, wobei die Trennhilfe (29) eine Plexiglasscheibe ist.

10. Verfahren nach einem der Ansprüche 4 bis 9, wobei das in Schritt (a) bereitgestellte Schichtsystems (1a, 8) so hergestellt worden ist, dass im Schichtsystem (1a, 8) bei genau einer Temperatur zwischen 20°C bis 200 C keine mechanischen Spannungen zwischen den Oberflächen der elastomeren Schicht (4) und den daran angrenzenden Oberflächen auftreten und die elastomere Schicht ausgehärtet ist.

11. Verfahren nach Anspruch 10, worin die Trennung

iiia.) durch Erwärmen des Schichtsystems oder Teilen davon auf Temperaturen, die wenigstens 100 °C, bevorzugt 150 °C oberhalb der Temperatur bei der keine mechanischen Spannungen zwischen den Oberflächen der elastomeren Schicht (4) und den daran angrenzenden Oberflächen auftreten, liegen
oder
iiib.) durch Abkühlen des Schichtsystems oder Teilen davon auf Temperaturen, die wenigstens 100 °C, bevorzugt 150 °C unterhalb der Temperatur bei der keine mechanischen Spannungen zwischen den Oberflächen der elastomeren Schicht (4) und den daran angrenzenden Oberflächen auftreten, liegen, erfolgt oder unterstützt wird.

12. Verfahren nach einem der vorangehenden Ansprüche, worin in Schritt (ii) die Vibration durch eine Vorrichtung zur Vibrationserzeugung, bevorzugt durch Ultraschall-Aktoren und besonders bevorzugt durch Piezo-Keramiken erzeugt und durch direkten mechanischen Kontakt von Festkörpern oder Kontakt vermittels einer Flüssigkeit von der Vorrichtung auf das Schichtsystem (1a, 8) übertragen wird.

13. Verfahren nach einem der vorangehenden Ansprüche, worin in Schritt (ii) ausschließlich der Träger (1) durch eine Vorrichtung zur Vibrationserzeugung zur Vibration angeregt wird.

14. Vorrichtung zum Durchführen eines Verfahrens nach einem der vorhergehenden Ansprüche, umfassend ein Haltemittel (28) zum Fixieren des ersten Trägers (1) und ein Haltemittel zum Fixieren des zweiten Trägers (20), wobei das Haltemittel (29) zum Fixieren des zweiten Trägers (20) als Trennhilfe (29) ausgestaltet ist, wie in einem der Ansprüche 7 bis 9 definiert und gegebenenfalls Mittel zum Erwärmen des Schichtsystems und/oder zum Erzeugen einer Vibration des Schichtsystems.

## Claims

1. Method for the mechanical separation of a laminar structure (8) from a carrier assembly (1a) comprising or consisting of a first carrier (1), wherein the laminar structure (8) comprises a wafer (7) and a second, extensible carrier (20), and wherein at least one plasma polymer separating layer (3) is disposed between the first carrier (1) and the wafer (7), said method comprising the following steps:

a) providing a layer system (1a, 8) comprising the carrier assembly (1a) and the laminar structure (8)
b) producing a mechanical stress in the region of the interface between the carrier assembly (1a) and the laminar structure (8), so that the laminar structure (8) is separated from the carrier assembly (1a), by a method comprising

i) the steps:

ia) providing a separating aid (29)
ib) fixing the separating aid (29) on the second carrier (20), and
ic) mechanically separating the laminar structure (8) from the carrier (1a) using only one separating front (33),

**characterised in that** the fixing of the separating aid (29) on the second carrier (20) is effected by means of reduced pressure or electrostatic charging so that during the separation procedure the second carrier (2) remains fixed on the separating aid (29) immediately behind a separating front (33) formed during the separation.

2. Method according to claim 1, wherein the separation in step b) is also effected or assisted by (ii) producing a vibration in the layer system.

3. Method according to one of claims 1 or 2, wherein the wafer (7) has a thickness of $\leq 150$ $\mu$m, preferably $\leq 80$ $\mu$m, particularly preferably $\leq 20$ $\mu$m and most particularly preferably a thickness of $\leq 10$ $\mu$m.

4. Method according to one of the preceding claims, **characterised in that** the layer system between the first carrier (1) and the wafer (7) includes a layer (2) of a hardened, partially hardened or hardenable elastomer material.

5. Method according to one of the preceding claims, wherein the layer system includes the following layers in the stated order:

a first carrier (1),
a layer (2) of elastomer material as described in claim 4,
a plasma polymer separating layer (3),
a wafer (7), and
a second carrier (20).

6. Method according to one of claims 1 to 5, wherein the separation takes place between the surface of the plasma polymer separating layer and the surface of the wafer.

7. Method according to one of the preceding claims, wherein the separating aid (29) is a flexible plate.

8. Method according to claim 7, wherein the first carrier (1) is fixed on a holding means (28), the flexible plate (29) and the holding means (28) each have at least one shaped portion, and wherein the force producing the separation acts between at least one shaped portion of the flexible plate (29) and at least one shaped portion of the holding means (28).

9. Method according to one of claims 7 or 8, wherein the separating aid (29) is a plexiglass disc.

10. Method according to one of claims 4 to 9, wherein the layer system (1a, 8) provided in step (a) was produced in such a way that, in the layer system (1a, 8) at exactly a temperature between 20°C to 200°C, no mechanical stresses develop between the surfaces of the elastomer layer (4) and the adjacent surfaces and the elastomer layer is hardened.

11. Method according to claim 10, wherein the separation takes place or is assisted by

iiia) heating the layer system or parts thereof to temperatures that are at least 100°C, preferably 150°C, above the temperature at which no mechanical stresses develop between the surfaces of the elastomer layer (4) and the adjacent surfaces, or
iiib) cooling the layer system or parts thereof to temperatures that at least 100°C, preferably 150° C, below the temperature at which no mechanical stresses develop between the surfaces of the elastomer layer (4) and the adjacent surfaces.

12. Method according to one of the preceding claims, wherein in step (ii) the vibration is produced by a vibration-generating device, preferably by ultrasound generators and particularly preferably by piezo ceramics, and is transmitted to the layer system (1a, 8) by direct mechanical contact of solid bodies or contact mediated by a liquid.

13. Method according to one of the preceding claims, wherein in step (ii) exclusively the carrier (1) is caused to vibrate by a vibration-generating device.

14. Device for carrying out a method according to one of the preceding claims, comprising a holding means (28) for fixing the first carrier (1) and a holding means for fixing the second carrier (20), wherein the holding means (28) for fixing the second carrier (20) is designed as a separating aid (29), as defined in one of claims 7 to 9, and optional means for heating the layer system and/or for generating a vibration of the layer system.

**Revendications**

1. Procédé de séparation mécanique d'un composite stratifié (8) d'un composite support (1a) comprenant un ou constitué d'un premier support (1), dans lequel le composite stratifié (8) comprend une tranche (7) et un deuxième support (20) extensible et dans lequel au moins une couche de séparation en polymère plasma (3) se trouve entre le premier support (1) et la tranche (7), comprenant les étapes suivantes :

   a) mise à disposition d'un système stratifié (1a, 8) comprenant le composite support (1a) et le composite stratifié (8)
   b) génération d'une tension mécanique dans la zone de la surface limite entre le composite support (1a) et le composite stratifié (8), de sorte que le composite stratifié (8) est séparé du composite support (1a), par un procédé comprenant

      i) les étapes de :

         i a) mise à disposition d'une aide à la séparation (29)
         i b) fixation de l'aide à la séparation (29) au deuxième support (20), et
         i c) séparation mécanique du composite stratifié (8) du composite support (1a) en n'exploitant exactement qu'un seul front de séparation (33),

   **caractérisé en ce que** la fixation de l'aide à la séparation (29) au deuxième support (20) se fait par dépression ou charge électrostatique de sorte que pendant l'opération de séparation le deuxième support (20) reste fixé directement derrière un front de séparation (33) généré lors de la séparation au niveau de l'aide à la séparation (29).

2. Procédé selon la revendication 1, dans lequel la séparation à l'étape b) se fait ou est soutenue également par (ii) génération d'une vibration dans le système stratifié.

3. Procédé selon l'une quelconque des revendications 1 ou 2, dans lequel la tranche (7) a une épaisseur $\leq 150\ \mu$m, de préférence $\leq 80\ \mu$m, de manière particulièrement préférée $\leq 20\ \mu$m et de manière tout particulièrement préférée une épaisseur $\leq 10\ \mu$m.

4. Procédé selon l'une quelconque des revendications précédentes, **caractérisé en ce que** le système stratifié comprend, entre le premier support (1) et la tranche (7), une couche (2) en un matériau élastomère durci, partiellement durci ou durcissable.

5. Procédé selon l'une quelconque des revendications précédentes, dans lequel le système stratifié comprend les couches suivantes dans l'ordre indiqué :

   un premier support (1),
   une couche (2) en matériau élastomère comme décrit dans la revendication 4,
   une couche de séparation en polymère plasma (3),
   une tranche (7) et
   un deuxième support (20).

6. Procédé selon l'une quelconque des revendications 1 à 5, dans lequel la séparation a lieu entre la surface de la couche de séparation en polymère plasma et la surface de la tranche.

**7.** Procédé selon l'une quelconque des revendications précédentes, dans lequel l'aide à la séparation (29) est une plaque flexible.

**8.** Procédé selon la revendication 7, dans lequel le premier support (1) est fixé sur un moyen de retenue (28), la plaque flexible (29) et le moyen de retenue (28) ayant chacun au moins une forme et dans lequel la force entraînant la séparation agit entre au moins une forme de la plaque flexible (29) et au moins une forme du moyen de retenue (28).

**9.** Procédé selon l'une quelconque des revendications 7 ou 8, dans lequel l'aide à la séparation (29) est une vitre en plexiglas.

**10.** Procédé selon l'une quelconque des revendications 4 à 9, dans lequel le système stratifié (1a, 8) mis à disposition dans l'étape (a) est fabriqué de telle sorte que, dans le système stratifié (1a, 8) à une température exactement entre 20 °C à 200 °C, aucune tension mécanique n'apparaît entre les surfaces de la couche élastomère (4) et les surfaces adjacentes à celles-ci et la couche élastomère est durcie.

**11.** Procédé selon la revendication 10, dans lequel la séparation a lieu ou est soutenue

iiia.) par chauffage du système stratifié ou de parties de celui-ci à des températures qui se situent au moins 100 °C, de préférence 150 °C au-dessus de la température à laquelle aucune tension mécanique n'apparaît entre les surfaces de la couche élastomère (4) et les surfaces adjacentes à celles-ci
ou
iiib.) par refroidissement du système stratifié ou de parties de celui-ci à des températures qui se situent au moins 100 °C, de préférence 150 °C en dessous de la température à laquelle aucune tension mécanique n'apparaît entre les surfaces de la couche élastomère (4) et les surfaces adjacentes à celles-ci.

**12.** Procédé selon l'une quelconque des revendications précédentes, dans lequel, dans l'étape (ii), la vibration est générée par un dispositif de génération de vibrations, de préférence par des actionneurs à ultrasons et de manière particulièrement préférée par des céramiques piézo et est transmise par contact mécanique direct de corps solides ou contact au moyen d'un fluide du dispositif au système stratifié (1a, 8) .

**13.** Procédé selon l'une quelconque des revendications précédentes, dans lequel dans l'étape (ii) seul le support (1) est animé d'une vibration par un dispositif de génération de vibrations.

**14.** Dispositif de réalisation d'un procédé selon l'une quelconque des revendications précédentes, comprenant un moyen de retenue (28) pour fixer le premier support (1) et un moyen de retenue pour fixer le deuxième support (20), dans lequel le moyen de retenue (29) pour fixer le deuxième support (20) est réalisé en tant qu'aide à la séparation (29), comme défini dans l'une quelconque des revendications 7 à 9 et le cas échéant moyen de chauffage du système stratifié et/ou de génération d'une vibration du système stratifié.

Fig. 1

Fig. 2

29  20  21  30  31

19  3

28  6  7

Fig. 3

33  34  3  20  29  21  31

19

28  2  6  7

Fig. 4

EP 2 382 656 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004051708 A

- WO 2007099146 A